(19) Europäisches Patentamt
European Patent Office
Office européen des brevets

(11) **EP 1 319 267 B1**

(12) **EUROPEAN PATENT SPECIFICATION**

(45) Date of publication and mention
of the grant of the patent:
**07.11.2012 Bulletin 2012/45**

(21) Application number: **01973898.8**

(22) Date of filing: **19.09.2001**

(51) Int Cl.:
*H03D 7/16* (2006.01)   *H03D 3/00* (2006.01)

(86) International application number:
**PCT/CA2001/001338**

(87) International publication number:
**WO 2002/025803 (28.03.2002 Gazette 2002/12)**

(54) **HILBERT SAMPLER/FILTER CIRCUIT**

HILBERT ABTAST- UND FILTERSCHALTUNG

CIRCUIT DE HILBERT POUR ÉCHANTILLONNEUR/FILTRE

(84) Designated Contracting States:
**DE FR GB**

(30) Priority: **19.09.2000 US 233660 P**
**19.09.2000 US 664788**

(43) Date of publication of application:
**18.06.2003 Bulletin 2003/25**

(73) Proprietor: **Kaben Research Inc.**
**Osgoode, Ontario K0A 2W0 (CA)**

(72) Inventor: **Riley, Tom**
**Osgoode, Ontario K0A 2WO (CA)**

(74) Representative: **Maillet, Alain**
**Cabinet Le Guen Maillet**
**5, place Newquay**
**B.P. 70250**
**35802 Dinard Cedex (FR)**

(56) References cited:
**EP-A- 0 519 891    US-A- 4 947 409**
**US-A- 5 400 366    US-A- 5 533 071**

## Description

Field of the Invention

The present invention relates to the demodulation of frequency modulated (FM) signals and to a complex valued delta sigma phase locked loop (PLL) demodulator. More specifically, it relates a Hilbert sampter/filter circuit.

Background to the Invention

Current mobile telephone handsets need to conserve as much power a possible to extend their battery life. Unfortunately, current FM demodulation techniques used in these handsets require multiple discrete components to implement. The multiplicity of these components leads to high power consumption and consequently, to shorter battery life. A single-chip demodulator would have lower power consumption and, theoretically, lead to longer battery life.

However, a single-chip demodulator is not the only requirement for the mobile handsets of the future. The demodulator must also provide some of the selectivity required in the receiver while simultaneously extracting the analogue FM information from the input IF signal. This is particularly important given the Advanced Mobile Phone System (AMPS)requirement for the demodulator to work properly with an interferer on the alternate channel only 60 kHz away from the desired signal on the assigned channel. The AMPS specification requires the receiver to continue to work properly when this interfering signal is 65 dB stronger than the desired signal.

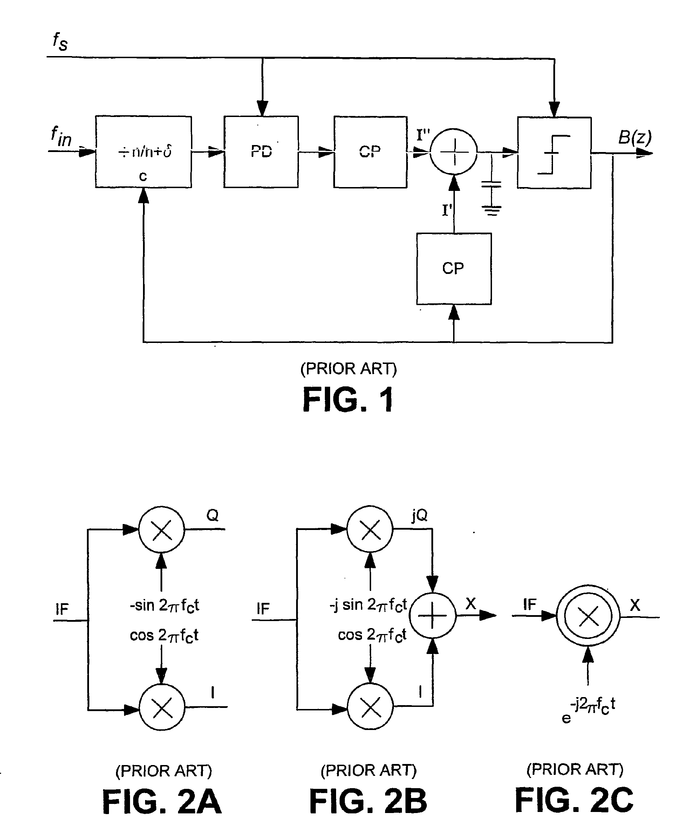

Regarding current demodulation techniques, one of the more recently researched that of a $\Delta\Sigma$PLL demodulator. A generalized schematic of this approach is illustrated in Figure 1. The principle of operation here is that the circuit is a $\Delta\Sigma$ modulator. When considered this way, the dual modulus divider (n/n+d) and phase detector (PD) provide the first integrator of a $\Delta\Sigma$ modulator. This assertion can be justified by considering that the phase detector detects phase which is inherently the integral of the divider output frequency. The two charge pumps (CP) then provide the second integration stage for a second order $\Delta\Sigma$ modulator.

The amount of quantisation noise.in the output bit stream for second order noise shaping depends on the reference frequency, $f_s$, and the step size of the divider, $\delta$. In general, the divider can divide by n or n+$\delta$ where $\delta$ might be less than 1. The spectral density of the quantisation error is given approximately by

$$\frac{\delta}{\sqrt{12}f_s}(1-z^{-1})^2\Big|_{=\exp)j2\Pi f/T_s)}$$

and the full scale input range for the FM deviation is $\delta f_s$. This is a high pass function which places zeros in the noise at dc. Other noise shaping functions are possible and discussed in the $\Delta\Sigma$ modulator literature.

In general the quantizer need not be restricted to a single bit quantizer. In this case, the output is a multibit.digital word, however we still refer to it as a bit stream. The full scale deviation is then p$\delta f_s$ where p is one greater than the number of digital levels in the bit stream. However, the demodulator of Figure 1 can also be seen as a PLL. From this PLL point of view, the dual modulus divider (n/n+$\delta$) is like a VCO. Applying more 1's to the divider control input (c) causes the divider to divide by the larger modulus more often and, as a result, to have a lower output frequency. The phase of this divider output is sampled relative to the reference frequency in the phase detector (PD). This sampling occurs at the divider output frequency and is integrated in the first charge pump (CP) loop filter. A second charge pump feeding back from the quantiser provides the stabilizing zero necessary for stability in a second order PLL. The presence of the quantiser in this PLL, however, complicates the PLL analogy and as a result the circuit is not often presented from this point of view.

Regardless of whether or not we find it more useful to regard the demodulator as a PLL, the resulting bit stream can then be processed either with digital filtering or analog filtering. If the bit stream is analog filtered with two or more poles in the filter, the high frequency noise can be rolled off to result in a white noise at some low level. It can then be passed directly to the speaker driver.

The primary limitation with this type of demodulator is that the input signal must be sufficiently band limited to remove interfering signals. As well, the signal must be hard limited before entering the demodulator. A practical reason for these requirements is that the input frequency is used to clock the digital logic making up the divider. Under these conditions, the signal must be filtered to the point where the zero crossings of the input signal are substantially unchanged by an interfering signal. In other words, the selectivity must come before the $\Delta\Sigma$ demodulator. This offers no hope of reducing the cost of the IF filter although it does offer a means of demodulation in a single IC.

Another way of looking at the need to filter before entering this demodulator is that both the divider and the edge triggered phase detector can process only information which is contained in the zero crossings of the input signal.

In the presence of a strong interferer, the zero crossings are dominated by this interferer, and the demodulator phase locks to the interfering signal. With a very large interferer, the small signal simply rides on top of the interferer and causes only a few zero crossings. As a result, the desired signal can be extracted only by looking at the amplitude information as well. With this theoretical consideration in mind, it seems unfortunate that the original $\Delta\Sigma$ FM demodulators as in Figure 1 threw away the amplitude information at the extreme front end of the demodulator.

One approach to demodulation and filters which is most helpful is to consider complex valued signals. The approach taken here is to show that simple phasors are used to describe real signals. This concept of phasors is then extended to include the concept of complex envelope for a bandpass signal. Neither of these constitute a complex signal even though they are complex representations of a real signal.

To take a simple example of the use of phasors, assume we want to find the sum of two voltages that are both sinusoidal functions of time.

$$s(t) = A_1 \cos(\omega_c t + \varphi_1) + A_2 \cos(\omega_c t + \varphi_2)$$

To avoid the process of summing up sinusoids in the time domain, each of the sinusoids above can be expressed in complex exponential form i.e.

$$\cos\theta = \frac{e^{j\theta} + e^{-j\theta}}{2} = \mathrm{Re}\{e^{j\theta}\}$$

From the above, it is clear that the imaginary part of $e^{j\theta}$ will always cancel with the imaginary part of $e^{-j\theta}$ and that the real part is in fact $\cos\theta$. Similarly, the sum of two sinusoids then becomes

$$A_1 \cos(\omega_c t + \varphi_1) + A_2 \cos(\omega_c t + \varphi_2)$$
$$= A_1 \frac{e^{j\omega_c t + \varphi_1} + e^{-j\omega_c t + \varphi_1}}{2} + A_2 \frac{e^{j\omega_c t + \varphi_2} + e^{-j\omega_c t + \varphi_2}}{2}$$
$$= \frac{1}{2}\left[(A_1 e^{j\omega_c t + \varphi_1} + A_2 e^{j\omega_c t + \varphi_2}) + (A_1 e^{(j\omega_c t + \varphi_1)} + A_2 e^{-j\omega_c t + \varphi_2})\right]$$

Here, the third line groups the sum into two positive frequency exponentials and the sum of two negative frequency exponentials. Again since the sum of two real signals must be another real signal, we would expect that the imaginary parts would cancel out. Some inspection of the equations will reveal that this is true. The convenience of phasor notation comes when we decide to ignore the negative frequency components. Since the imaginary parts of the sum cancel out, and the real parts of the positive frequency components are equal to the real parts of the negative frequency components, we can see that

$$A_1 \cos(\omega_c t + \varphi_1) + A_2 \cos(\omega_c t + \varphi_2)$$
$$= \mathrm{Re}\{(A_1 e^{j\varphi_1} + A_2 e^{j\varphi_2})e^{j2\Pi f_c t}\}$$

Thus for example, in a 50 Hz transformer ($f_c = 50$ Hz) we get all the information we need from looking at only the term in brackets.

$$A_1 e^{j\varphi_1} + A_2 e^{j\varphi_2}$$

This is the well known phasor addition of the two sinusoids that we started with. By further ignoring the common factor of $e^{j2\pi fc1}$, the time dependency has been eliminated and only complex constants remain. Note that we end up with fixed constants for the term in brackets (the phasor) because all the signals we are looking at are at the same frequency, $f_c$.

The phasor concept can be extended to the complex envelope of a bandpass signal. Suppose that we let each of the phase offsets in the previous phasor example be a function of time, $\phi(t)$,

$$If\, \varphi(t) = (\omega_c + \omega_1)t\, and\, \varphi_2(t) = (\omega_c + \omega_2)t, then\, the\, sum\, of\, the\, two\, \sin usoids\, is$$
$$A_1 \cos(\omega_c t + \omega_1 t) + A_2 \cos(\omega_c t + \omega_c t)$$
$$= \frac{1}{2}\left[ (A_1 e^{j\omega_1 t} + A_2 e^{j\omega_2 t})e^{j2\pi f_c 1} + (A_1 e^{-j\omega_1 t} + A_2 e^{-j\omega_2 t})e^{-j2\pi f_c t} \right]$$

The complex envelope of the sum of the two sinusoids is just the term.

$$A_1 e^{j\omega_1 t} + A_2 e^{j\omega_2 t}$$

Where the same term produced a static complex number for the phasor, the sum of two sinusoids of differing frequencies produced a complex value that is a function of time. We can now use a complex mathematical representation but the signal stays real. As with phasors, it is again possible to ignore both the negative frequency components and the carrier frequency, $f$. This type of analysis is routinely carried out in digital communications texts. If two sinusoids are summed, the phasors of each sinusoid are now functions of time and rotate relative to the carrier frequency.

The addition of two sinusoids results in the expected AM modulated sinusoid at a new frequency. The frequency of the AM modulation is given by the difference in frequency between the two sinusoids we are summing. The simple concept of envelope commonly seen on an oscilloscope relates to the amplitude of the AM modulation which is quite visible in the upper sinusoid. That is, at any point in time there is an envelope shown with a dotted line. The new concept which extends the old familiar concept of an envelope is to also look at the phase of the upper sinusoid relative to the phase of some arbitrarily chosen carrier frequency and phase. By having an amplitude and a phase, we have the polar representation of a complex signal. As with any complex signal, the magnitude and phase can also be represented as inphase and quadrature components.

However, clearly, the world we live in doesn't have any j operators and thus there are no true complex signals. However, many circuits contain two real signals that we would like to behave the same way as one complex signal. One way to define complex signal is to describe a way to make one.

An obvious example of use to radio work is a In-phase and Quadrature downconverter. Figure 2(a) shows a standard block diagram for an "In-phase" and Quadrature mixer. Figure 2(c) shows an abstract mathematical modem for same mixer.

To get the abstract model of the hardware, we can use a transitional model, shown in Figure 2(b). To get this model, we need only to believe that j means "the other wire" and from then on we can think of X = I +jQ as one complex signal rather than two real signals. The j operator in the middle figure allows us to mathematically add the two signals to obtain figure 2(b) while keeping the I and Q channels separate. This addition has no corresponding component in either the hardware or the abstract model but it is fundamental to the understanding of complex filters from the point of view presented here. The transitional model, showing this addition, is therefore particularly useful because it allows recognition of the hardware in the block diagram while at the same time providing the abstract model through mathematical manipulations.

By thinking of the two real signals as one complex signal, it becomes easier to design filters for the two signals. The motive for filtering two real signals is conceptually related to the motive for using phasors or complex envelopes. Just as using a complex envelope simplifies the mathematical analysis of a real high frequency signal, the filtering of two real signals (which we hope represent the high frequency signal) can be simpler to construct than a filter for the original high frequency signal.

To represent a complex signal, at least two real signals are required. Additional signals can provide redundancy and more robust implementations. For example, if both the inphase signal and the quadrature signal are provided with their complimentary (180° phase shifted) counter parts, then there are four signals and balanced circuit techniques can be used to improve power supply rejection ratio. Similarly, the use of other redundant signals phase shifted by multiples of 45° or 5°, for example, may provide other opportunities for more robust embodiments of complex filters. Thus, a complex signal is in general represented by a plurality of real signals.

Another technique for generating complex signals is the Hilbert Transform or Hilbert Filter, see for example document US 5 533 071 A. An ideal Hilbert filter rejects all negative frequency exponentials while passing positive frequency exponentials. That is, given a real input (composed of equally weighted positively rotating exponentials and negatively rotating exponentials), a Hilbert Filter provides a complex output (composed of only the positively rotating exponentials). Another way of looking at the same thing is to say that the output must have a real channel with the original input signal and an imaginary channel with each sinusoidal component of the input phase shifted by exactly 90 degrees. When looking at it this way, the ideal Hilbert filter is more commonly called the Hilbert transform.

One can simply consider the Hilbert transform or Hilbert Filter as a special case of a more general class of filters called complex filters. The distinguishing feature of such filters is that they have a different frequency response for positively rotating exponentials than for negatively rotating exponentials. Thus a real input can produce a complex output by substantially removing for example, negatively rotating exponentials.

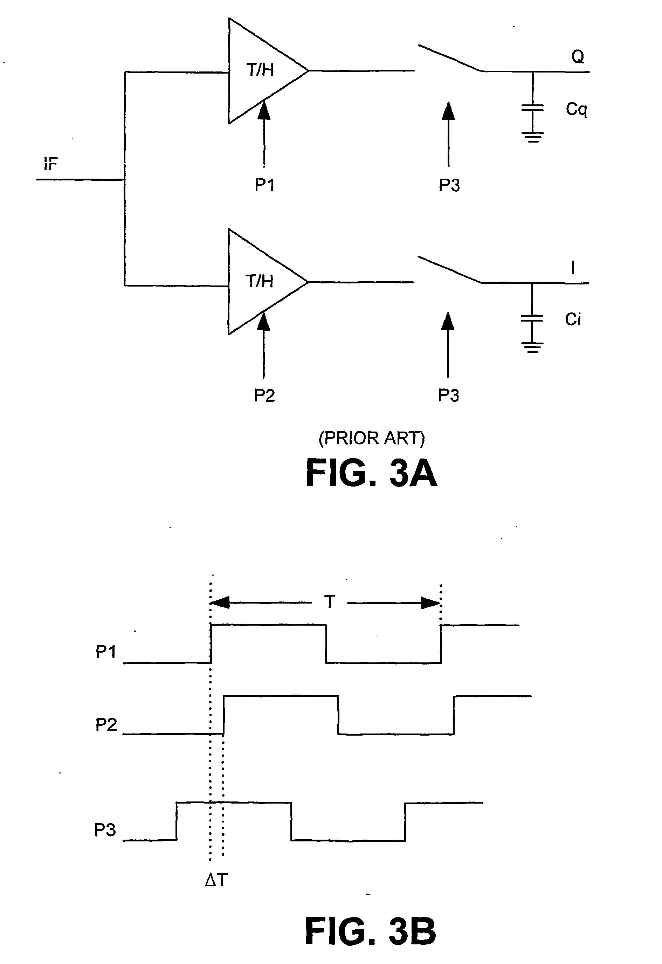

The above are not the only methods of obtaining complex signals. Complex signals can also be obtained by sampling. Figure 3A shows an example where an IF signal is sub-sampled with a small time shift in the quadrature sample. P1 and P2 are phases that tell the Track and Hold amplifiers to hold their input value when the phases P1 or P2 are high. P3 then samples the held values coming out of the track and hold amplifiers on the falling edge of P3. Figure 3B shows the timing diagrams associated with the circuit of Figure 3A.

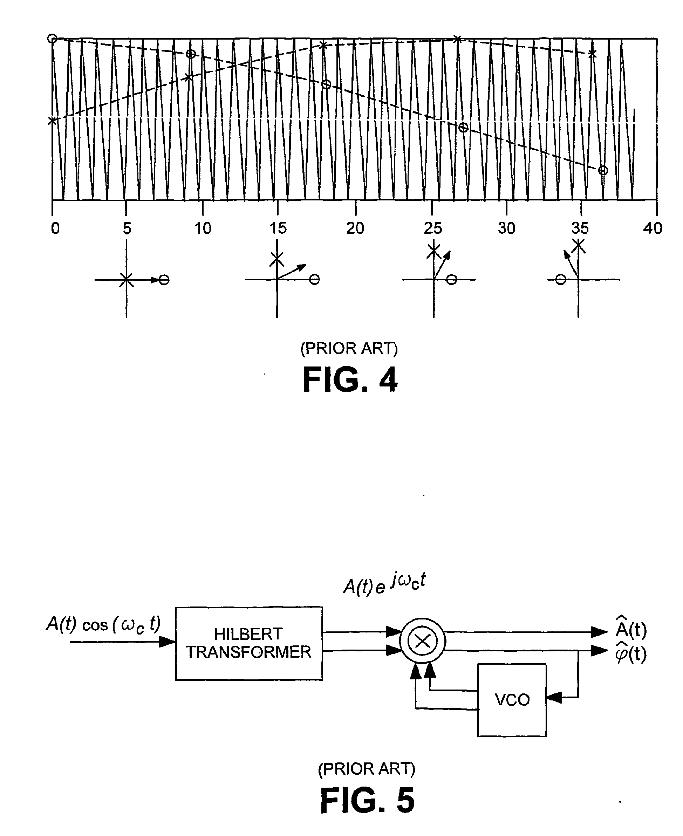

We can now consider an example where the P1 and P2 phases have an offset, $\Delta T$; of 3/4 of the IF period and a sampling period, T, equal to 10 cycles of the nominal IF frequency. Specifically, for a 45 MHz nominal IF frequency we are sampling at 4.5 MHz and $\Delta T = 4/(135 \text{ MHz}) = 29.6\text{ns}$. Figure 4 shows the voltages sampled onto the holding capacitors for an input frequency slightly faster than 45 MHz. By visualizing these samples as components of a complex number, we can see that they represent a positively rotating complex exponential. This is illustrated by the timing diagrams of Figure 4.

Both the I channel and the Q channel display familiar aliasing behavior and the sampling produces a down-conversion through this aliasing. It can also be seen that the I channel follows a low frequency cosine function while the Q channel follows a low frequency sine function. Thus, I + jQ follows a positively rotating complex exponential.

Now that complex signals can be obtained, they can also be used in a_PLL. When so used, a complex valued phase locked loop (CVPLL) is obtained. A complex-valued PLL (CVPLL) can be analyzed in terms of Figure 5 below. The incoming signal can be Hilbert transformed by either an inphase and quadrature downconversion or by a complex filter or a combination of both. The result will be a complex exponential represented by two real signals with some impairments depending on the accuracy of the Hilbert transform. A second component of the PLL is a VCO which produces an inphase and quadrature output. This output can be thought of as another complex exponential which we wish to phase lock to the incoming complex exponential from the Hilbert transform. The last component is a full complex multiplier which is used as a phase detector and amplitude demodulator.

The operation of the PLL can be understood by ignoring, for now, the hardware and studying the mathematical operations the circuit is intended to perform. The Hilbert transform (which may include a downconversion not shown in the figure) will give us two signals, I and Q representing the phasor of the incoming signal. Mathematically, this phasor can be expressed in either Cartesian form, I +jQ, or polar form, $Ae^{j\theta}$. Figure 5 shows the polar form of the signal because the phase we wish to lock in this PLL is the phase angle of the complex number. More specifically, the VCO also has a phase angle for its complex exponential output which we want to phaselock to the incoming signal. Mathematically, the way this happens is that the VCO carrier frequency and the incoming carrier frequency terms cancel out in the complex multiplication leaving only a small signal $\phi(t)$ to control the VCO frequency. Since the phase of the VCO depends on the integral of $\phi(t)$, $\phi(t)$ must be small when the loop is locked.

One of the features of the CVPLL is that this loop band-width can be higher than the carrier frequency of the signal it is trying to lock to. The reason for this is that the phase detector provides a continuous indication of the phase error without the usual double frequency components of conventional PLLs. The continuous signal from the phase detector continuously corrects the VCO input voltage to produce the correct frequency and phase.

Both the $\Delta\Sigma$ PLLs and the CVPLLs above are forms of broad band PLL capable of rapid acquisition and FM demodulation. The $\Delta\Sigma$ PLLs provide high bandwidth by working in discrete time and oversampling the bandwidth of the modulated signal. The CVPLLs provide high bandwidth by using continuous time feedback to the VCO. In the $\Delta\Sigma$ PLLs, the demodulated FM output comes from the bit stream which can be low pass filtered to recover the original FM modulated signal. In the CVPLLs the demodulated FM output is available from the VCO input.

Although the $\Delta\Sigma$PLLs have the advantage of requiring no precision components, they require extensive filtering in front of the demodulator at the intermediate frequency. The phase response of this filter reduces the linearity of the overall demodulator. It is also expensive to obtain narrow band temperature-stable filters to meet these requirements at higher intermediate frequencies.

The CVPLLs have the advantage of retaining both the amplitude and phase information of the incoming signal. This allows further processing of the signal after it is demodulated. One difficulty for the CVPLL when used in an integrated circuit is that a low noise VCO can be difficult to obtain on chip. A continuous time VCO can also be vulnerable to interference from repetitive or pseudo-random digital signals on the same chip. Another difficulty is that the linearity of the demodulator is limited by the linearity of the VCO tuning characteristic.

Summary of the Invention

Shortcomings of the prior art as discussed above may be avoided by providing a complex valued delta sigma Phase Locked Loop (PLL) demodulator. The demodulator is a multiple stage demodulator. The first stage is a conversion stage which converts an incoming signal into a first complex representation. The second stage is a direct digital synthesizer (DDS)/mixer which synthesizes a signal to be mixed with the first complex signal and performs the mixing operation to produce a second complex output. This second complex signal is controlled by a bitstream fed back from the third stage - a phase quantizer stage. The bitstream represents the quantized phase difference between the synthesized signal and the first complex signal. The DDS/mixer stage then measures the synthesized signal for any phase difference from the incoming signal through the feedback inherent to a PLL, the bitstream thus provides an output that gives the frequency of the desired signal. As a side benefit, the real component of the second complex signal, provides an amplitude estimate of the desired signal.
An embodiment the present invention provides a Hilbert sampler/filter circuit according to claim 1.

Brief Description of the Drawings

A better understanding of the invention may be obtained by reading the detailed description of the invention below, in conjunction with the following drawings, in which:

Fig 1 is a block diagram of a delta sigma phase lock loop according to the prior art;
Fig 2(a), 2(b), and 2(c) are different representations of an inphase and quadrature mixer according to the prior art;
Fig 3A is a diagram of a track and hold sampler according to the prior art;
Fig 3B is a timing diagram for the circuit of Fig 3A;
Fig 4 is a timing diagram for quadrature voltage sampling according to the prior art;
Fig 5 is a complex valued phase locked loop according to the prior art;
Fig 6 is a block diagram of a complex valued delta sigma phase locked loop;
Fig 7 is a Hilbert Sampler/filter for use with the circuit of Fig 6;
Fig 8 is a sampler cell of the Hilbert Sampler/Filter of Fig 7;
Fig 9 is a timing diagram for the circuit of Fig 7 illustrating one possible use of the circuit;
Fig 10 is a timing diagram illustrating another possible use of the circuit of Fig 7;
Fig 11A and 11B are two possible timing diagrams for a 12 phase extension of the circuit of Fig 7;
Fig 12 is a Hilbert Sampler/Filter circuit similar to that of Fig 7 but implemented using MOS technology;
Fig 13a is a more general version of a . Hilbert sampler/filter circuit;
Fig 13b is a sampler cell which can be used in the in the circuit of Fig 7 in place of the sampler cell of Fig 8;
Fig 14 is a dual cell sampler/filter element;
Fig 15 is a possible timing diagram for the circuit of Fig 14 ;
Fig 16 is a sampler/filter circuit similar to the circuit of Fig 7 but with a passive filter after each sampler cell;
Fig 17 is a sampler/filter circuit according to an embodiment of the invention which can use the concept of rotating capacitors to sample and filter a signal;
Fig 18 is a timing diagram for the switches in the circuit of Fig 18;
Fig 19 is a sampler cell of the circuit of Fig 17;
Fig 20 is a demodulator with a frequency offset and a bandpass filter incorporated in the mixer stage;
Fig 21 is an example of a mixer stage implementation using a digital phase accumulator;
Fig 22 is another exampler of a mixer stage implementation which includes passive filtering;
Fig 23 is a diagram of a heterodyne PLL ;
Fig 24 is a diagram of a subsampled heterodyne PLL;
Fig 25 is a diagram of a long loop demodulator with multiple mixer substages;
Fig 26 is a simplified schematic diagram of a one pole complex filter that uses switched capacitors, and
Fig 27 is a schematic diagram of a switch matrix which can be used to implement a switching sequence to the filter in Fig 26.

Detailed Description of the Preferred Embodiments

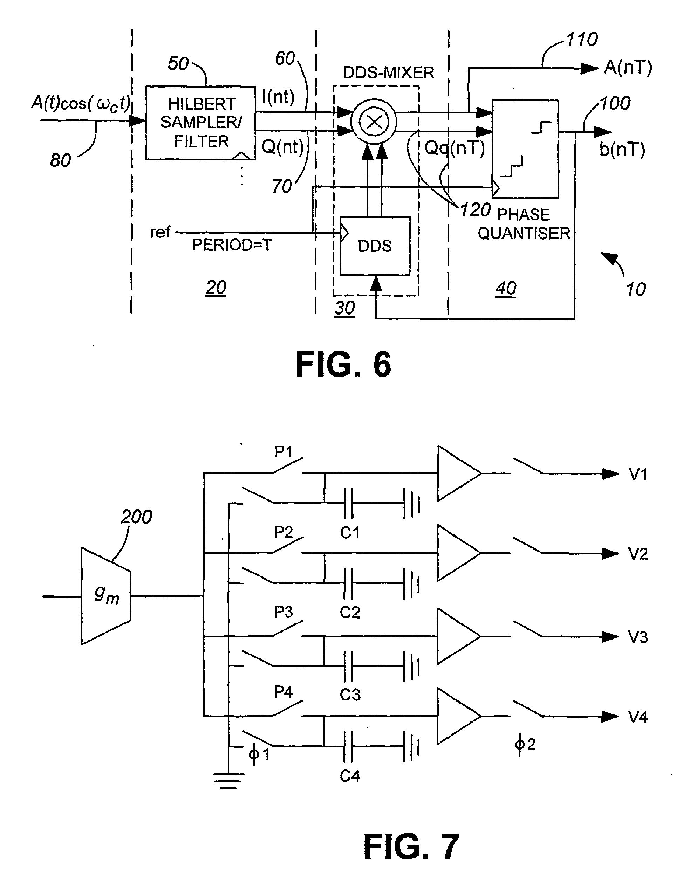

Referring to Figure 6, a demodulator 10 is illustrated. The three stages of the demodulator are as follows: a conversion stage 20, a mixer stage 30, and a phase quantizer stage 40. In the following description the demodulator 10 will be referred to as a CV$\Delta\Sigma$PLL meaning a complex valued delta sigma phase locked loop demodulator. To try to make the description more clear some assumptions are made so that CV$\Delta\Sigma$PLL can be described by example. One of these assumptions is that the IF frequency which the CV$\Delta\Sigma$PLL is required to demodulate is 45 MHz . Also low side LO frequencies are assumed everywhere. In cases where a resulting second (or third etc.) IF involves a complex signal, it is assumed that the positive rotating exponential is desired rather than the negative rotating exponential. Clearly the functionality and implementation techniques described here apply equally well to other IF or LO frequencies and equally well to negatively rotating exponentials as well as positively rotating exponentials for complex signals.

The CV$\Delta\Sigma$PLL obtains and processes amplitude information by using in phase and quadrature samples of the input signal. These provide a complex representation of the input signal as a phasor with Cartesian components. In a preferred embodiment, some sampled signal, $x_1$ has a real and an imaginary part, once it is sampled. Linear filtering can then be performed on these components. Other operations can be performed more "easily" when the signal is treated as a magnitude, $M_1$, and a phase, 6, Since it is ultimately the rate of change of phase (frequency), $f_1$, which we wish to extract from the signal, the CV$\Delta\Sigma$PLL can be thought of as a $\Delta\Sigma$ phase locked loop like the previous $\Delta\Sigma$ PLLs with the exception that now the amplitude information is available as an output rather than thrown away at the very front end.

The CV$\Delta\Sigma$PLL can be viewed as an extension of existing $\Delta\Sigma$ techniques by adding PLL concepts, or as an extension of existing PLL techniques by using noise shaping and discrete time signal processing. The approach used here to explain the demodulator comes at it from the PLL point of view.

As can be seen from Figure 6, the CV$\Delta\Sigma$PLL consists of:

- a Hilbert Sampler/Filter 50 which provides a complex representation of the continuous time input signal having an inphase 60 and quadrature 70 signals to represent the phasor or complex envelope of the input signal 80.
- a DDS-mixer 90 which performs a discrete phase shift (or rotation in the complex plane) of the input inphase 60 and quadrature signals 70 in response to a bitstream output signal 100 (nT) to produce two signals, A(nT) and Qq (nT), (the amplitude output 110 (A(nt)) and an intermediate complex signal 120 (Qq(nT))
- a phase quantiser which quantises the phase angle of the complex signal A(nT) + j Qq(nT) to produce the bitstream signal b(nT) 100.

The bitstream output 100 is fed back to the DDS-Mixer which corrects the phase of the complex signal A(nt) + j Qq(nT). The phase angle of A(nT) + j Qq(nT) is decreased if the phase signal angle is greater than 0 and increases the phase angle if the phase angle is less than 0.

One key feature which distinguishes the CV$\Delta\Sigma$PLL from the CVPLL is the use of discrete time analog processing for the quantisation of the phase error and the phase shift introduced by the DDS-mixer. This allows the use of a DDS-mixer combination instead of a continuous time VCO and a mixer combination. The presence of a quantiser also distinguishes the CV$\Delta\Sigma$PLL from the CVPLL (Figure 5).

The feature which distinguishes the CV$\Delta\Sigma$PLL from the $\Delta\Sigma$PLL is the use of complex signals to retain both the magnitude and the phase of the input signal or equivalently both the inphase and quadrature components of the input signal.

Within the context of the CV$\Delta\Sigma$PLL, there is a wide variation of possible architectures and implementations. These variations, involve variations in the Hilbert Sampler/Filter, the DDS-mixer and the optional use of filtering and/or extra downconversion stages between the DDS-mixer and the Phase-Quantiser.

Variations in the Conversion Stage

The primary function of the Hilbert Sampler/Filter 50 is to provide an in-phase and quadrature representation of the input signal to pass on to the DDS-Mixer. An optional.secondary function is to filter undesired signals from the input signal or to filter undesired signals added within the Hilbert Sampler/Filter itself.

The Hilbert Sampler/Filter function can be realized with either:

- IQ down-conversion alone,
- complex filtering alone,
- sampling alone, or
- sampling in conjunction with discrete time filtering.

Sampling in the Hilbert Sampler/Filter is not necessary if the subsequent stages, the DDS-Mixer and the phase quantiser, can function with continuous time signals.

In the case of IQ downconversion alone, some low pass filtering would be required to remove the negative frequency components at $-f_{IF}-f_c$. The quality of the in-phase and quadrature match will limit the removal of frequency

components at $-f_{IF}-f_c$. This in turn will limit the accuracy of the phase angle of the complex signal intended to describe the IF phasor or complex envelope.

The IQ downconversion could be obtained in very conventional ways. For example, an ECL divide by 4 circuit could be used to divide a 178 MHz reference down to an ($f_c$ = 44.5 MHz) in-phase and quadrature LO. Then two Gilbert-cell mixers could downconvert the IF signal. The low pass filtering could then consist of just two RC low pass filters to attenuate the frequency components at $-f_{IF}-f_c$. If these parameters do not provide enough attenuation, then the second IF frequency $-f_{IF}-f_c$ could be reduced to a lower frequency, or the order of the filter increased.

Alternatively, if downconversion is not desired to reduce the operating frequencies of the subsequent components in the CV$\Delta\Sigma$PLL, then the in-phase and quadrature signals may be obtained by directly filtering the IF signal with a complex filter. By setting the imaginary input to the complex filter to ground and the real input of the filter to the IF signal, we can tell the filter that its input is J +jQ where the imaginary part, Q, is set to zero and the real part, I is the (real) IF signal. The output of the complex filter then provides a complex signal at 45 MHz. The accuracy of the two resulting signals (as a representation of the complex envelope of the input signal) is limited by the matching of the components in the filter.

Another alternative would be to sample the input signal. For any sampling frequency chosen, it is necessary to filter the 45 MHz IF signal to sufficiently anti-alias it before entering the CV$\Delta\Sigma$PLL or before the sampling operation occurs within the Hilbert Sampler/Filter.

Other techniques are available to obtain in-phase and quadrature samples. For example, two track and hold amplifiers could be used. By switching the two amplifiers into hold mode at different times, separated in time by a delay equal to 1/4 of an IF period, or (n+ 1/4) of an IF period where n is an integer. The track and hold amplifiers must have sufficient bandwidth for the 45 MHz IF signal even if they are sampled at a rate substantially less than 45 MHz. Another example would be to use one track and hold amplifier to produce both the I and Q outputs in a multiplexed stream. Depending on the details of the subsequent components of the CV$\Delta\Sigma$PLL, these signals may have to be demultiplexed and/or retimed to be compatible with the other components.

Optionally, discrete time filtering may be used to reduce negative frequency exponentials in the complex representation made by I' +j Q'. Just as a continuous time complex filter can derive in-phase and quadrature signals from a real input signal, a discrete time complex filter can be used to obtain a complex representation of a single sampled signal by suppressing the negatively rotating exponentials. The filtering may also be used to reduce the effects of interfering signals and noise.

However, it is preferred that the conversion stage be a Hilbert Sampler/Filter. Figure 7 illustrates such a Sampler/Filter. As can be seen, the Sampler/Filter has:

- a circuit element 200 with:
- a transconductance Gm, resistance or other conversion means to obtain a current proportional to the input IF signal,
- a series of sampling phases, P1 ... Pn, only one of which is high during a predetermined time interval, which provide complex co-efficients of an FIR filter by switching the destination of the current source to one of,
- a predetermined number of capacitors, to integrate the current over each of the predetermined time intervals when the current is sent to that capacitor,
- a means to transfer the charge, or the information associated with the charge, on some or all of the capacitors to the next stage after the Hilbert Sampler/Filter or to subsequent filter stages within the Hilbert Sampler/Filter.

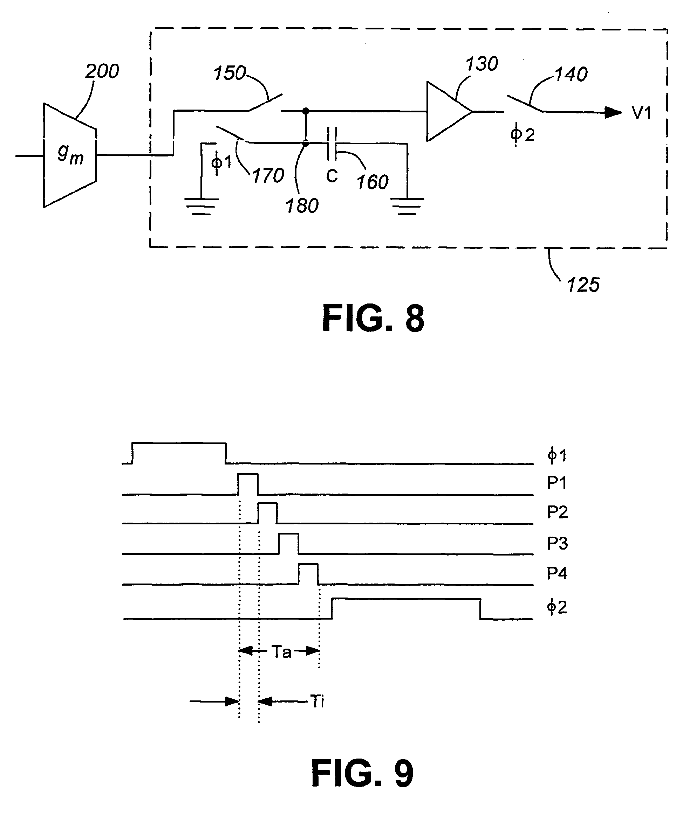

The circuit can be generalized as a number of sampler cells, each sampler cell 125 as shown in Figure 8. As can be seen, each sampler cell has a buffer 130, a data transmission switch 140, a sampler switch 150, a capacitor 160, a grounding switch 170, a first connection point 180. The circuit element 200 with transconductance Gm is coupled to each sampler cell. In Figure 7 and 8, $\phi_1$, represents the time the grounding switch 170 is closed. $\phi_2$, represents the time the data transmission switch 140 is closed.

The key feature of this type of sampler is that the signal is integrated over an entire interval rather than sampled at the end of an interval. By arranging the timing of Ti and Ta (Ti represents the time interval that each of the sampler switches is closed while Ta is the total time interval between the closing of the first sampler switch P1 to the opening of the last sampler switch Pn), each of the phases P1 to Pn can function as complex coefficients of an FIR filter, prior to an ideal sampling. The previously discussed complex filters provided only delay functions, $e^{-snT}$, to form the basis of a filter prior to sampling. Then, by selecting how the samples were used, complex coefficients could be introduced to reduce negative frequency exponentials. The new complex filters provided by this sampler provides an improved filter element $(e^{-s(n+1)T} - e^{-snT})s$. The phases P1 to Pn can then be used to provide complex coefficients of an FIR filter to reduce negative frequency exponentials prior to sampling.

A simple version of this sampler can be built as shown in Figure 7. In this simple case, there are only 4 phases and 4 capacitors. Each capacitor voltage integrated during P1, P2, P3 or P4 is buffered with a unity gain buffer and applied to subsequent filtering stages or the DDS mixer during $\phi$2. The switches clocked on $\phi$1 and $\phi$2 and the unity

gain buffer are one means of sampling the charge stored in the capacitors and transferring the information to later stages. Other means of transferring this charge to the DDS mixer are discussed later. As part of this scheme, the capacitor voltages are reset to ground during $\phi1$.

In this, and all examples to follow, it is assumed that only 1 sampler switch is closed during any one time interval. At the detailed circuit design level, switches have finite rise and fall times on the switch control signals. It can be difficult to assure that P2 rises at precisely the same time P1 falls. Further, it may be desirable to have some overlap so that, in this example, P2 rises before P1 falls. Thus, when we say only one sampler switch is closed during any one time interval, this is meant as a first level of understanding only. In practice, the phrase is intended to include embodiments where there is substantial overlap between each sampling interval and the next as well as when there is a gap between time intervals.

A typical timing diagram might be as follows in Figure 9. Here, Ta is the aperture time of the sampler, or the time interval over which the sample is made. In this example Ta is included in neither the time when $\phi1$ is active nor the time when $\phi2$ is active. That is, it has its own time slot. In this example, the time slot for Ta occurs between $\phi1$ and $\phi2$. Clearly, many other arrangements are possible, or may be required to adapt to other components used with the sampler.

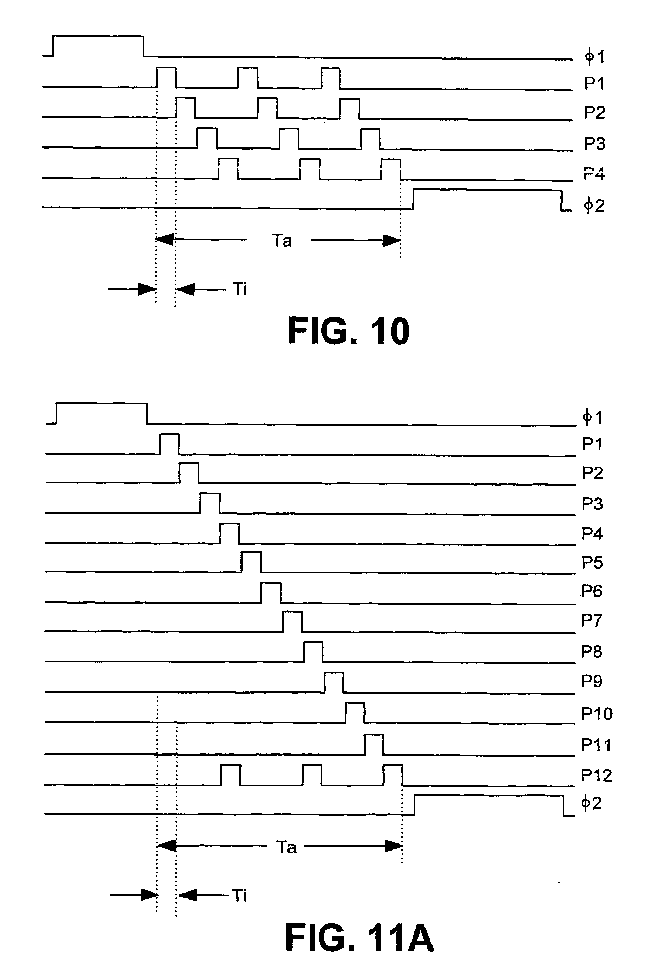

The Hilbert Sampler/Filter of Figure 7 may also optionally include repeated sequences of complex tap coefficients. For example, the switch controlling the current to C1 could close two or more times within the aperture time Ta. An example where each switch is closed 3 times is illustrated in the timing diagram of Figure 10. Keeping Ti constant, Ta increases and.the filter becomes more selective.

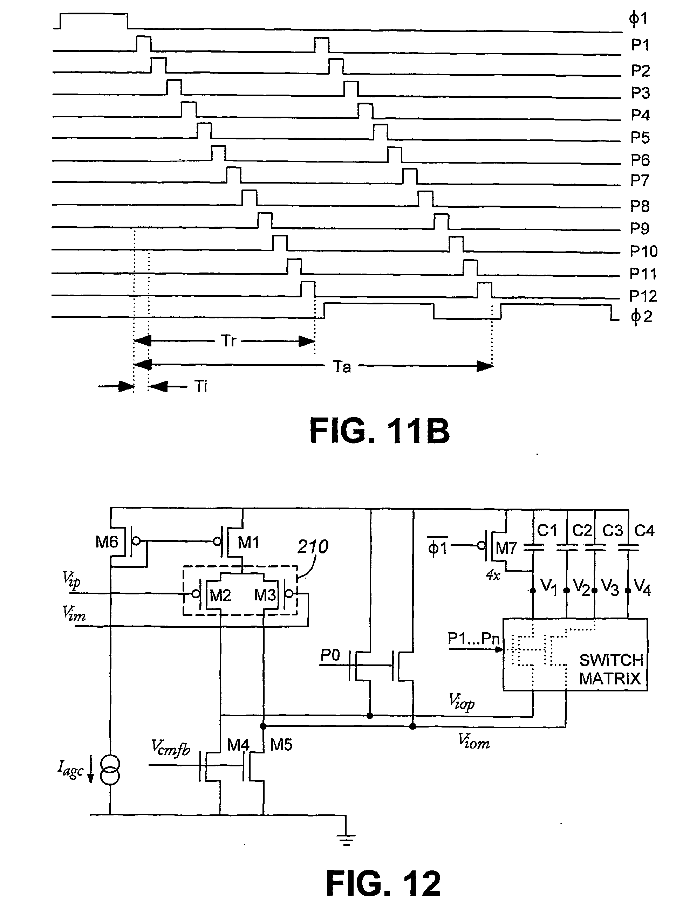

In the previous example there were 4 phases - one for each capacitor. For one capacitor to integrate over 3 time intervals, Ti, each phase went high 3 times. As an alternative, the same function can be provided with n phases, P1 to Pn each of which is high only once during Ta. For example, to achieve the same filter prior to sampling as the previous example, we could pick n = 12. Then the timing diagram would be as shown in Figure 11.

The timing diagram of Figure 11 can be obtained simply by "unrolling" the timing diagram of Figure 10. Thus, P1, P5 and P9 in Figure 11 correspond to the three times the first phase (P1) of Figure 10 went high.

Now three switches controlled by P1, P5, and P9 control when the current is switched to Cl. Clearly the other capacitors receive current in a similar way under the control of the other phases. This arrangement is particularly convenient when Ta is equal to the period, Tr, of some reference clock already available on an integrated circuit for other purposes. Then the phases P1 to Pn can be obtained from a Delay Locked Loop locked to this reference.

The two techniques may also be combined such that the phases P1 to Pn repeat, for example as shown in the Figure 11B where Ta = 2Tr. Clearly, the approach could be extended to Ta = pTr where p could be more than 2. Also, not all of the available time intervals need to be used. To be even more general, it should be noted that Tr could result from dividing down some higher frequency reference.

Another layer of generality may be added by including some additional logic such that P1 assigns the current to a particular capacitor during one cycle of the reference but to some other capacitor during another cycle of the reference. By also including logic such that the current may be switched directly to ground without going through a capacitor, the phases P1 to Pn can also generate coefficient of value 0 in addition to 1, j, -1 and -j.

So far we have assumed that Ta < Ts where Ts = l/$fs$ is the period of sampling the charge stored onto the capacitors. This restriction may be avoided by using multiple instances of the sampler. By having two or more samplers that are well matched, the sampler can be pipelined such that one sample becomes ready every Ts seconds while the others are in the process of completing their sample. Mismatch in the capacitors or transconductances result in different gains on each of the interleaved samplers. With the voltage-buffer charge sampling means shown in these examples capacitor mismatch causes the same difficulty.

While the above circuit only had four sampler cells, multiple cellular Sampler/filter circuits can easily be constructed. The timing diagrams of Figures 11A & 11B can also be applied to a sampler/filter circuit such as that illustrated in Figure 7 but with twelve sampler cells instead of four. This has the advantage of reducing the quantization step size S.

Figure 12 illustrates one way to build the transconductance element (200 in Figure 8)and switches (150 in Figure 8) in an integrated circuit. Figure 12 shows a schematic of one way to build the charge sampler in an integrated circuit. In this example, the circuit element 200 is a differential pair 210. The input voltage is applied to a differential pair of MOS transistors whose $g_m$ is controlled by the tail current of the differential pair. This provides an adjustable transconductance $g_m$ which can be used for AGC in the receiver. It also provides a differential current source. Most of the common mode current of this differential pair is then absorbed by a pair of common mode feedback transistors while some of the common mode current and all of the difference mode current is cascoded into either the positive supply or into two of the four capacitors.

The switches of the sampler are provided by NMOS transistors with their gate voltage controlled by the phases P1 to Pn. By setting the high level for P1 to Pn at 2.5 V rather than the 5V supply, a virtual ground is provided to reduce the effects of non-linear output impedance of the current source. To assure that this virtual ground is maintained at all times, a new phase P0 is provided which is high whenever the other phases are not.

This way, the cascode transistors for the folded cascode are also used as switches to determine which load capacitor, if any, gets the difference mode current and residual common mode current. Each load capacitor then integrates the current over the duration of the time that the switches connecting it to the current source are closed. CI is assigned to represent the inphase channel sample and C3 to represent its compliment (or phase shifted by 180 degrees). Similarly C2 is assigned to represent the quadrature channel and C4 to represent its compliment. Now by arranging the P1 to Pn phases to switch the current into one of the 4 capacitors, the switches can be used to form complex tap coefficients of an FIR filter. If capacitor C1 accumulates a voltage interpreted as the inphase component, any time interval above current is switched to provides a +1 co-efficient for a top of an FIR filter. Similarly, if C2 accumulates the complimentary voltage to C1, time intervals assigned to this capacitor provide -1 top co-coefficient. C3 and C4 can be further used to provide +j or -j coefficient. Coefficients of value 0 can be provided by PO which shunts the current to the positive supply.

This example does not illustrate the buffer (130 in Figure 8) and transmission switch (140 in Figure 8) of each cell. The nodes $V_1$ $V_2$ $V_3$ and $V_4$ correspond to the first connection point (180 in Figure 8) for each of the four cells.

This example illustrates a four phase sampler, where the complex tap coefficients of the filter are restricted to the set {0, +1, -1, +j, -j}. That is, it can provide tap coefficients of magnitude 0 or 1 where the coefficients of magnitude 1 can have four angles, separated by 90 degrees in the complex plane. The example can be readily extended to provide an 8 phase filter with 8 cells. Then, the 8 cells provide tap coefficients of magnitude 0 or 1 where the coefficients of magnitude 1 can have 8 angles, separated by 45 degrees in the complex plane. Generally, tap coefficients of separation 360/N degrees in the complex plane can be provided by N sampling cells. FIR sampling filters can then be formed by selecting a particular sequence of tap coefficients through the sequence of closing switches in the switch matrix.

In this case, the grounding switches (170 of Figure 8) are provided by the PMOS transistor M7 (only one of 4 is shown). Each of these shorts a capacitor to ground during $\phi_1$. Ground in this example is the positive supply but in general it can be any predetermined voltage.

A number of issues must be taken into account when using this approach. An adequately accurate phase shift of 180 degrees between Vip and Vim is required. Specifically, common mode voltage fluctuations at 45 MHZ should be avoided. The exact relationship between Iagc and the amount of gain control obtained is process dependent.

The current source, Iagc, may be used in a feedback loop developed later in the discriminator which detects the amplitude of the desired signal after filtering. Alternatively it may be a D/A converter. The amplitude of the desired signal should be adjusted to allow overhead for the undesired alternate channel within the linear range of the sampler. This AGC feedback signal could also provide the RSSI signal required in other parts of the receiver.

The voltage source, *Vcmfb,* is intended to be used as.common mode feedback to pin the common mode of the sampled output to a suitable voltage below the positive supply. There are at least two options for developing the CMFB voltage. One option is to force the opamps in the complex resonator to transfer the difference mode charge onto the integrating capacitor without affecting the common mode charge. Another option is to add a second set of sampling capacitors and arrange the switches such that only common mode charge is integrated. In either case, we can be left with a common mode voltage, $V_{cm}$, on a capacitor which can be sampled and used to develop $V_{cmfb}$.

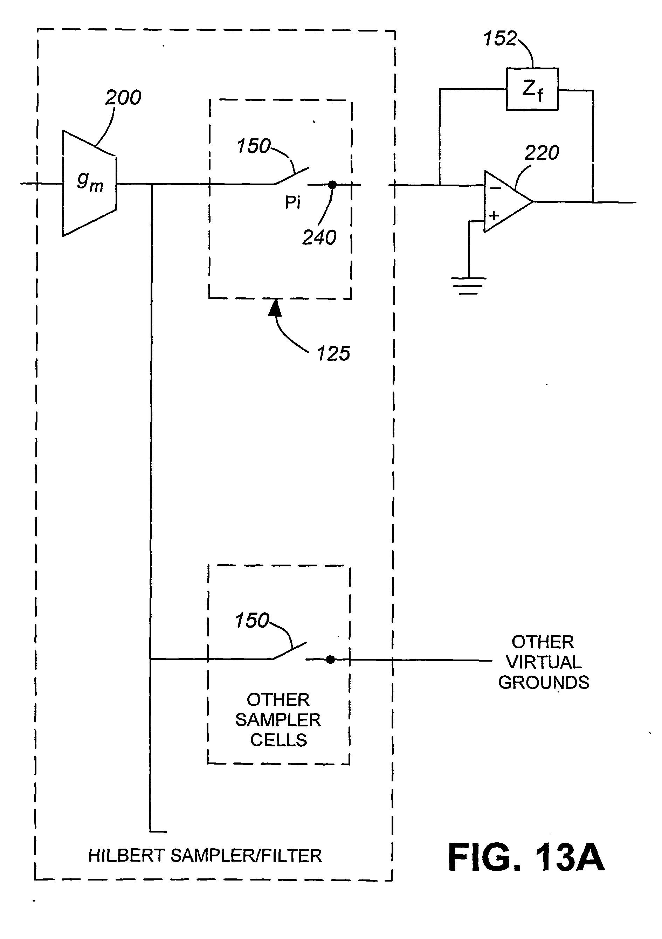

However, the structure of Figure 8 is not the only way to construct a sampler cell for a Hilbert Sampler/Filter. The sampler cell may also be completed by transferring the charge to a virtual ground 240. This is illustrated by example in Figure 13a where the virtual ground is formed by an opamp 220 and a feedback impedance 152 placed after the Hilbert Sampler/Filter. Since the transconductance element drives a virtual ground in this embodiment of the Hilbert Sampler/Filter the requirements for output impedance and compliance voltage of the circuit element are reduced. As a result, this is the preferred embodiment of the Hilbert sampler/filter. It comprises: a circuit element having a transconductance and a plurality of sampler cells, each sampler cell comprising a sampler switch coupled between the circuit element and a virtual ground; wherein for the plurality of sampler cells, only one sampler switch is closed during any one time interval.

There are many other virtual grounds available in the literature other than the inverting input of an amplifier. The term virtual ground is intended here to encompass any technique that holds the voltage of the virtual ground close to a predetermined voltage through feedback. This includes techniques such as a cascode transistor where the feedback may be internal to the transistor or external to the transistor through gain boosting.

Just as in the embodiment of Figure 12, the number of phases in the sampler/filter is determined by the number of sampler cells. Similarly, the number of available tap coefficients and their separation (in degrees) in the complex plane is determined by the number of virtual grounds. Also as with the embodiment of Figure 12, the sequence of the tap coefficients is determined by the sequence of switch closings.

Similarly to the embodiment of Figures 8 and 12, this embodiment of the Hilbert sampler/filter may further comprise a sampler cell coupled between the circuit element and a ground to provide a tap coefficient of value O.

The Hilbert sampler/filter may also further comprise additional filtering provided by the feedback. For example, if the feedback impedance 152 in Figure 13a were a resistor in parallel with a capacitor, a real, single-pole low pass filter would be provided in addition to the FIR filter provided by the sampler cells and the circuit element.

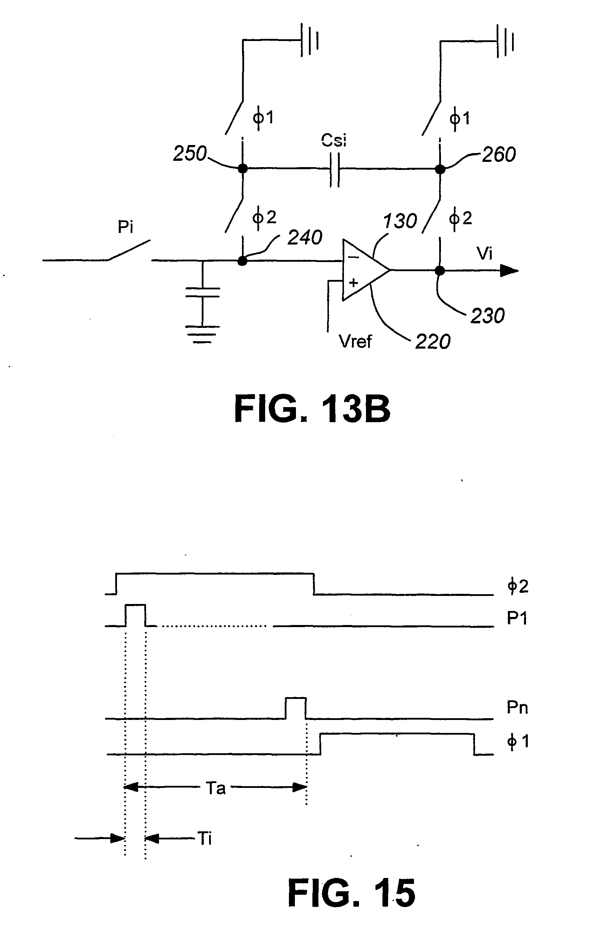

Figure 13b illustrates a sampler cell where this feedback impedance is a switched capacitor resistor.

As can be seen, the sampler cell of Figure 13 has a sampling switch *Pi*, a sampling capacitor Ci, a filtering capacitor Csi, primary switches clocked by $\phi_1$, and secondary switches clocked by $\phi_2$.

A first sampler node 230, second sampler node 240m third sampler node 250, and a fourth sampler node 260 are illustrated in the figure.

From the figure, a primary switch clocked by $\phi_1$ is between ground and the fourth sampler node 260. Another, primary switch clocked by $\phi_1$, is between the third sampler, node 250 and ground. The filtering capacitor is coupled between the third (250) and fourth (260) sampler nodes a secondary switch $\phi_2$ is between the second (240) and third (250) sampler nodes while the other secondary switch $\phi_2$ is between the first (230) and fourth (260) sampler nodes. The operational amplifier 220 is coupled between the second (240) and first (230) sampler nodes. The negative input of the opamp is coupled to the second (240) sampler node while the positive input is coupled to a reference voltage VREF. The sampling switch Pi is between the second (240) sampling node and the cell input. The sampling capacitor Ci is coupled between ground and the second (240) sampler node.

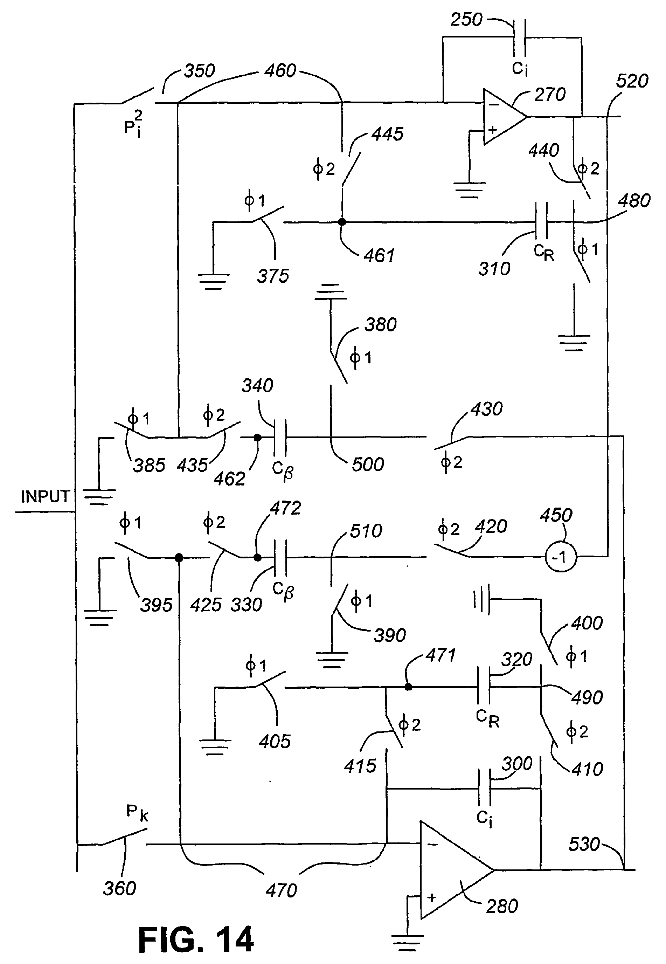

The feedback impedance may also be made complex by the circuit shown in figure 14. The pair of sampler cells in Figure 14 have a phase separation of 90 degrees. That is one represents an inphase component and the other a phase shifted version of the complex signal. Traditionally the phase shift between the two is 90 degrees so that the other component is a quadrature component but with more than two phases other phase shifts are possible. Clearly, the single pole filter shown in Figure 14 could be extended to a biquad or cascode of biquads using well known techniques commonly applied to discrete time filtering.

Figure 14 illustrates a pair of sampler cells. The pair of cells have a pair of operational amplifiers 270, 280, a pair of filtering capacitors Ci (290, 300), primary sampling capacitors 310, 320 (Cr), secondary sampling capacitors (Cp), 330, 340, a first sampling switch 350 for the first cell and a second sampling switch 360 for the second cell. Also shown in the diagram are eight primary sampling switches 370, 375, 380, 385, 390, 395, 400, 405 and eight secondary sampling switches 410, 415, 420, 425, 430, 435, 440, 445. Also included in the pair of sampler cells is a negator 450. For ease of description, a number of nodes are also identified:

- first intermediate node 460
- second intermediate node 470
- third intermediate node 480
- fourth intermediate node 490
- fifth intermediate node 500
- sixth intermediate node 510
- a seventh intermediate node 461
- an eighth intermediate node 471
- a ninth intermediate node 462
- a tenth intermediate node 472

along with a first output node 520 (the output of opamp 270, and a second output node 530 (the output of opamp 280).

The first sampling switch 350 is between the input to the cell pair and the first intermediate node. The second sampling switch 360 is between the input to the cell pair and the second intermediate node. The first intermediate node is coupled to the negative input of the opamp 270. The second intermediate node is coupled to the negative input of the opamp 280. Both positive inputs of the two opamps 270, 280 are coupled to ground. Each of the filtering capacitors 290, 300 are coupled across the negative input of an opamp and the output of the same opamp.

Coupled between the seventh intermediate node 460 and the third intermediate node 480 is a primary sampling capacitor 310. Similarly, the second primary sampling capacitor 320 coupled between the eighth intermediate node 471 and the fourth intermediate nodes 490. The secondary sampling capacitors 340 is coupled between the ninth intermediate node 462 and the fifth intermediate node 500. The other secondary sampling capacitor 330 is coupled between the tenth intermediate node 472 and the sixth intermediate node 570.

Concerning the primary and secondary sampling switches, the eight primary sampling switches are each coupled between ground and one of the following nodes: the third, fourth, fifth, sixth, seventh, first, second and eighth intermediate nodes. Of the eight secondary sampling switches, one (410) is coupled between the second output node 530 and the fourth intermediate node. Similarly, another (440) is coupled between the 3rd intermediate node and the first output node 520. Another (switch 430) is coupled between the fifth intermediate node 500 and the second output node 530. Another secondary sampling switch 420 is coupled between the sixth intermediate node 510 and the negator 450. The negator 450, in turn is coupled between the secondary sampler switch 420 and the second output port 520. The fifth secondary sampler switch 445 is coupled between the seventh and the first intermediate node. Another secondary sampler switch (435) is between a primary sampler switch (385) and the ninth intermediate node. A further secondary sampler switch (425) is between another primary sampler node (395) and the tenth intermediate node. The final secondary sampler switch 415 is between the second intermediate node and the eighth intermediate node.

In the circuit of Figure 14, the sampling capacitors are $C_R$ and $C_\beta$. The phases P1 to Pn may be contained within one of the switched capacitor phases. Alternatively, Ta may occur during one of the switched capacitor phases. The circuit of Figure 14 can be clocked with the timing indicated in Figure 15 to show an example where Ta occurs during $\phi$1. With this arrangement of the timing, the current source can drive a virtual ground.

The circuit of Figure 14 is shown single ended for clarity; it may be better to use differential circuitry with common mode feed-back. Then, P3 would provide the compliment of P1, P4 would provide the compliment of P2 in a phase example. The technique can be readily extended to more phases.

Another means of transferring charge from the sampler is to use passive switched capacitor techniques. This can also be used to provide additional filtering The absence of opamps may make the passive approach more linear and more suitable to low voltage applications. In this case, the means of transferring charge out of the sampling capacitors is simply a series of switches connecting the capacitors to the next stage of the Hilbert Sampler/Filter or the DDS-Mixer.

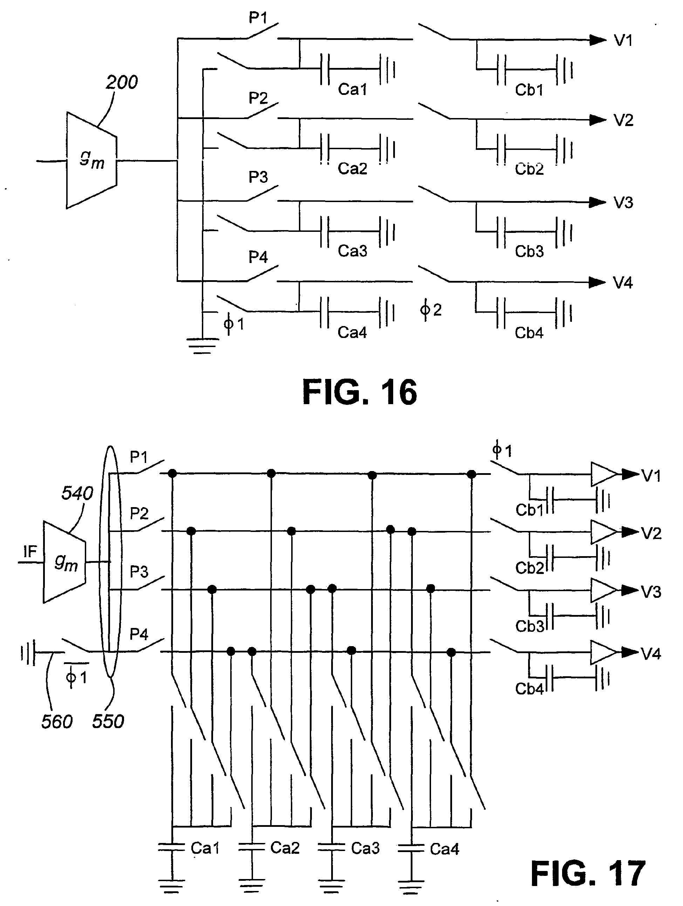

An example is shown in Figure 16. In this case charge balance equations on any one of the output voltages give

$$V(z) = \frac{1}{C_T}\frac{1}{1+yz^{-1}}Q_i(z)\, Where\, C_T = C_a + C_b\, and\, Y = C_b \,/\, C_r.$$

Thus, each pair of $C_a$ and $C_b$ capacitors forms a single pole real filter. Now if each of these filters match the others, we have the same filter applied to each of the I and Q channels as well as there compliments. Under these conditions we have the equivalent of a real filter applied to a complex signal.

Complex filtering may be provided in many ways to improve the rejection of negative frequency exponentials.

It should be noted that the circuit of Figure 16 is similar to that of Figure 7. However, each sampler cell of Figure 16 has an extra filtering capacitor ($Cb_x$) after the sampler switch $\phi$2.

The concepts embodied in the sampler/filter illustrated so far may be extended to apply to a new type of discrete time complex filter which is made up of:

- an information sampling means which can sample three or more phase-shifted versions of the input signal, shifted uniformly through 360 degrees in the complex plane, producing three or more corresponding phases;
- one or more groups of information storage means where each individual information storage means in a group stores information for each phase of the sampling means and provides a value to represent this information;
- optionally, a means of transferring information from one group to the next and finally to an output group if there is more than one group.
- one or more groups of information sharing means for sharing information between the previous time value of each phase and a rotating phase-shifted version of the previous-time value of each phase; and
- a means to pass some or all values of the output group to other circuits.

The filter has been described here in very abstract terms because it could provide a discrete-time digital filter as well as a discrete-time analogue filter, The discrete-time digital filter (and the discrete-time DDS-Mixer to follow) could be used after A/D conversion in a digital filter built of adders and multiplexers or with fixed point DSP in a microprocessor. Either of these options would require some intelligent noise shaping approach to round off error.

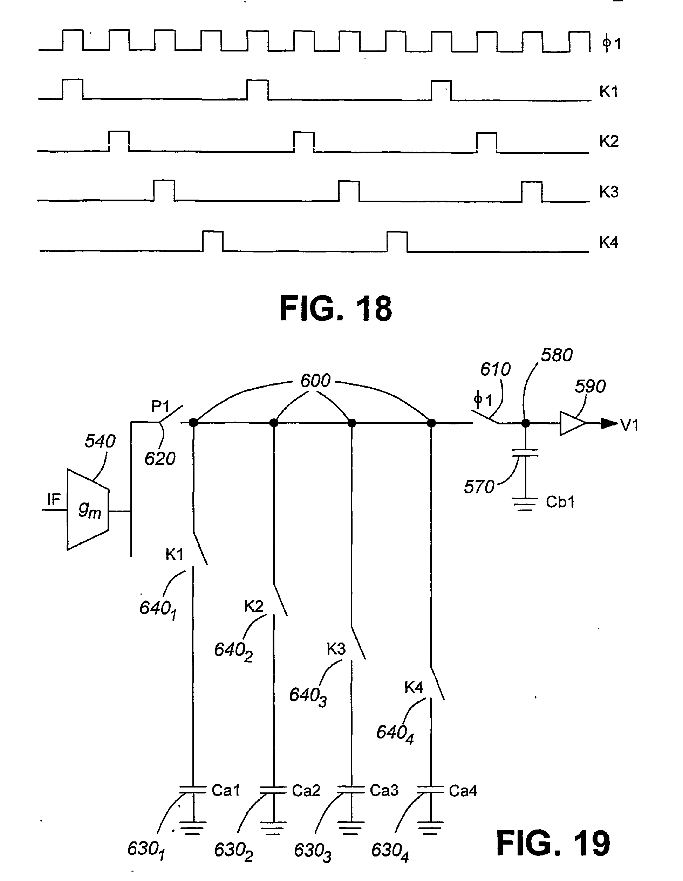

One example of an analogue four-phase 1-group filter according to the invention is shown in Figure 17. In this case the information sampled is charge sampled by integrating current over the time intervals P1 to P4. The information storage means are each equally weighted capacitors of the $C_b$ group of capacitors. The information sharing means are each equally weighted capacitors of the $C_a$ group of capacitors, the switch control signals K1 to K4 and the switches operating under the control of KI to K4. The phases K1 to K4 are arranged to be active during the time when $\phi$1 is active and to have the same duration as $\phi$1 Each of these phases K1 to K4 have a period of 4 times the period of $\phi$1 and are phased such that only one of them is active at any one time so that each cb capacitor is connected to one $C_a$ capacitor during $\phi$1, as illustrated in the timing of diagram of Figure 18.

As can be seen from Figure 17, the sampler/filter circuit can be viewed as a collection of primary sampler cells, each of which can be connected to a collection of secondary sampler cells. A circuit element 540 with a transconductance Gm is coupled at a common node 550 to a grounding switch 560 which is, in turn, coupled to ground. The common node 550 couples each of the primary sampler cells to the circuit element 540.

Figure 19 illustrates a single primary sampler cell coupled to four secondary sampler cells. As can be seen from Figure 19, a first capacitor 570 (Cb1) is coupled between ground and a first connection node 580. Between the node 550 and a primary sampler cell output V1, is a buffer 590. Between the node 570 and a second connection node 600 is an activation switch 610 ($\phi$1).

Between the node 600 and the circuit element 540 is a sampling switch 620 (P1). Coupled to the node 600 are the secondary sampling cells. Each of these secondary sampling cells are coupled to the node 600 by an array of coupling switches. Each secondary cell is composed of a second capacitor $630_1$, $630_2$, $630_3$, $630_4$, coupled between ground and a corresponding coupling switch, $640_1$, $640_2$, $640_3$, $640_4$. By closing one of these coupling switches, any one of the second capacitors can be coupled to the primary sampler cell. Between Figures 17 and 19, it should be clear that any one of the secondary sampler cells can be coupled to any one of the primary sampler cells.

The key feature illustrated in this passive filter is that one set of capacitors rotates relative to another set of capacitors. For example, in Figure 17 capacitor $C_{b1}$, is connected to capacitor $C_{a1}$ then to $C_{a2}$, $C_{a3}$, $C_{a4}$, and back to $C_{a1}$. This process repeats indefinitely. The point of this arrangement is that on each connection, $\phi1$, the $C_{b2}$ capacitor is connected to a $C_a$ capacitor which was previously connected to $C_{b2}$. Thus on every connection phase, a charge sharing operation occurs between the previous voltage V1 and the previous voltage V2 through the capacitors $C_{b1}$ and one of the $C_a$ capacitors.

Any of the sampler/filter circuits discussed above, and their equipments or extensions, can be used for the conversion stage of the CV$\Delta\sum$PLL demodulator.

Variations on the Mixer Stage

Since the CV$\Delta\sum$PLL demodulator needs to mix and phase lock to a specific frequency, PLL concepts call for a signal to mix the incoming signal with. Experience and experiments dictate that a direct digital synthesizer (DDS) provides the best results for the CV$\Delta\sum$PLL. Thus, in the following discussion, the mixer stage will be referred to as a DDS-Mixer.

It should be noted that, as the conversion stage produces 2 signals, the inphase and the quadrature representations of the demodulator input, the DDS-Mixer receives both these signals.

The primary function of the DDS-mixer is to provide discrete phase shifts of the output of the Hilbert Sampler/Filter. These phase shifts respond to the output of the Phase Quantiser to provide a negative feedback adjusting the phase of the DDS-mixer output toward some predetermined value. An accumulation means, typically a digital phase accumulator, (DPA) responsive to the output bit stream, b(nT), integrates the bit stream to provide a state, $\theta$, which indicates the required degree of phase shift for the input signal, $X_{0s} = I+jQ$. The mixer part of the DDS-mixer provides an output $X_{r1} = A + jQq$ such that $X_{r1} = X_{os} e^{-j\theta}$. A wide variety of circuits to accomplish this are presented in the literature and are known to those versed in the art.

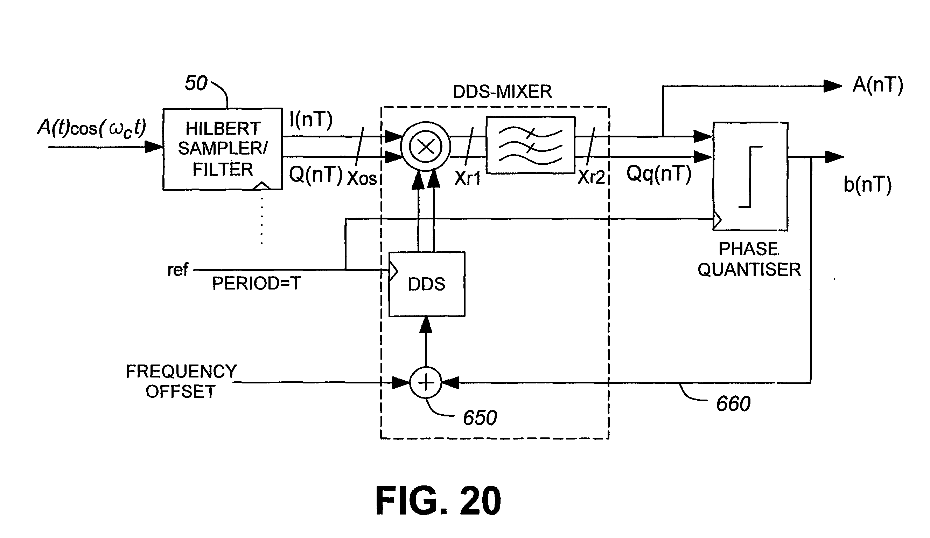

The DDS-Mixer may also provide a frequency offset control. When this is provided, additional frequency offsets may be removed from the Hilbert Sampler/Filter output. Figure 20 shows an example where a digital adder 650 is used to add the frequency offset control to the bit stream, b(nT) 660. In cases where the digital phase accumulator (DPA) provides a separate carry input for the LSB and the bit-stream, b(nT), is a single bit bit-stream, the frequency offset control can consist of applying a frequency offset control word to the main DPA input and the bit-stream to the carry input of the DPA.

The DDS-Mixer may also optionally provide additional filtering to provide a filtered output, $Xr_2(nT) = A(nT) +j Qq(nT)$. This filtering provides reduction of undesired signals present in the original IF input, or reduction of undesired signals introduced by the DDS-Mixer or Hilbert Sampler/Filter. Generally, this filtering could be either real or complex.

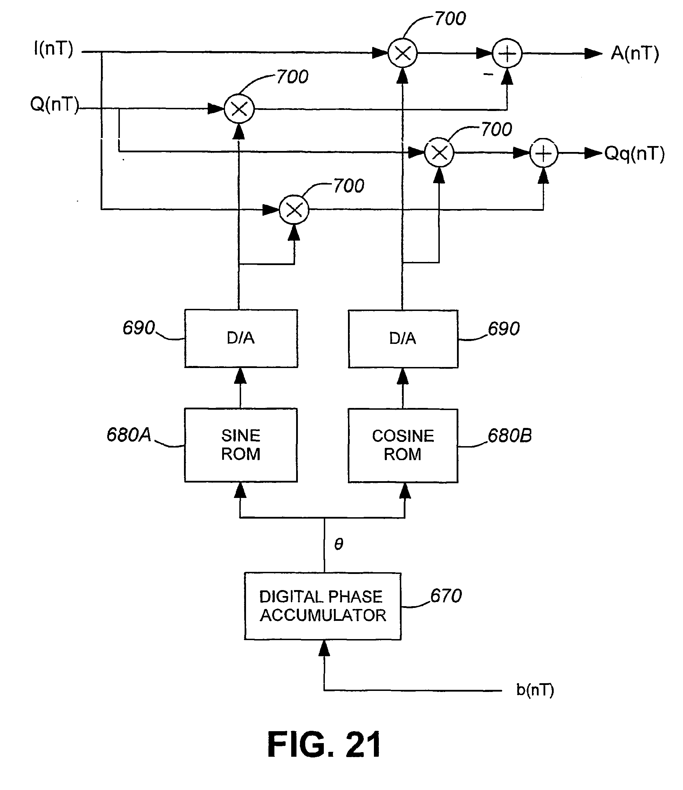

A simple implementation of the DDS/mixer combination is presented in Figure 21. In a conventional DDS the input frequency is accumulated in a phase accumulation register 670, to provide a value, $\theta$, representing the DDS phase. The output phase is then passed to a sine 680A and cosine 680B lookup ROM to provide the complex output after a pair of D/A converters 690. In the simple implementation, each of the sampled inputs would then have to be multiplied by the real and imaginary outputs from the DDS. The four quadrant multiplication mean 700 could then take the form of a Gilbert cell multiplier or some other equivalent. Clearly this implementation would be complicated. The lookup ROMS and mixers can be replaced with switched capacitor circuits.

When three or more phases of the Sampled sign are available, a DDS mixer with a phase resolution corresponding to the number of available phases can be produced through the mixing properties of the switch matrices discussed for filtering.

As with the DDS-Mixers previously described, an accumulator responsive to the output' bit stream, b(nT), integrates the bit stream to provide a state, $\theta$, which.indicates the required degree of phase shift for the input signal, $X_{os} = I+jQ$. Two approaches to making the switches have been identified. One approach is to have a digital decode and dedicated switches. That is for example, a 16 x 16 switch, can be made up of 256 individual switches of which 16 at a time can be turned on to connect 16 phases on one side of the switch to 16 phases on the other side of the switch with the desired degree of rotation controlled by digital logic. Alternatively, the switches may be connected in series to perform the decoding directly from the state of a digital phase accumulator. Combinations of the two approaches are, of course, also possible.

One method of implementing the DDS-Mixer with additional filtering uses switched capacitor techniques as described. To simplify the DDS, its resolution is reduced to 4 bits or 16 possible states. As a result, $\theta$ can take on only 16 possible values. In the example presented here, $\theta$ is accumulated in a digital phase register (as in a conventional DDS) however the value in the phase register is used to directly select one of 16 possible phase shifts of the sampled signal. This avoids the need to implement the ROMs D/As and mixers.

Mathematically, we wish to generate

$$X_{rl} = A' + jQ'_q$$

from the input signal
$X_{os}$ = I + jQ which is provided by the Hilbert Sampler/Filter
That is we want

$$X_{rl} = \dot{X}_{os}e^{-j\theta}$$

and pass this to the opamp rather than the original sampled signal. In terms of real and imaginary parts, the above expression becomes

$$Re(X_{rl}) = Re(X_{os}) \cos\theta - Im(X_{os})\sin\theta$$

$$Im(X_{rl}) = Re(X_{os}) \sin\theta + Im(X_{os})\cos\theta$$

With the quadrature sampler, phase shifts of n/2 or multiples of n/2 are easily performed by swapping and/or inverting the in-phase and quadrature samples. In this way the two MSBs of the 4 bit DDS/mixer can be implemented with only switches. The remaining 2 bits require phase shifts of multiples of $\pi/8$. These can be arranged through capacitor ratios shifting only a portion of the charge between the sampler's in-phase and quadrature channels. The above equation suggests that maybe the sampled charge (on each channel) could be divided into two portions; for example on the in-phase channel, a portion of the charge proportional to $\cos\theta$ would remain on the in-phase channel while a portion of the charge proportional to $\sin\theta$ would be passed to the quadrature channel. While this suggestion is true, it turns out that it cannot be implemented with two capacitors because, in general,

$$\sin^2 (\theta) + \cos^2 (0) = 1 \text{ and } |\sin(\theta)|+| \cos(\theta) \neq 1.$$

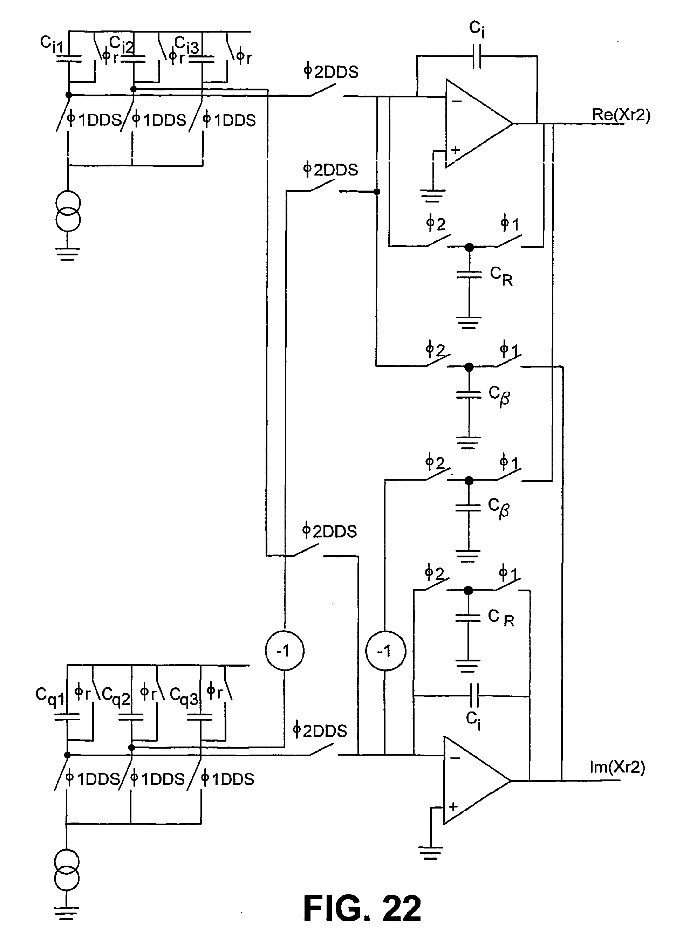

This causes difficulties because the total charge sampled onto only two capacitors cannot be divided up into two portions proportional to $\cos\theta$ and $\sin\theta$ for all values of $\theta$. As a result, a third capacitor, $C_{i3}$ and $C_{q3}$ is needed on each of the in-phase and quadrature channels as shown in Figure 22.

In Figure 22, the practice of showing the circuit single ended is used again for clarity and simplification. Here the transconductance is shown as a simple current source switched onto the load capacitors for a period $\phi_{is}$. In this scenario, we sample a charge, Q, onto $C_{i1}$, $C_{i2}$, and $C_{i3}$. Since the same voltage occurs across the three capacitors, the charge in the capacitors is

$$Q_i = Q_i \frac{C_{1i}}{C_T} + Q_i \frac{C_{2i}}{C_T} + Q_i \frac{C_{3i}}{C_T}$$

and similarly for the quadrature channel,

$$Q_q = Q_q \frac{C_{1q}}{C_T} + Q_q \frac{C_{2q}}{C_T} + Q_q \frac{C_{3q}}{C_T}$$

Both of these sampled charges together can be expressed in complex notation as, $Q_s = Q_i + jQ_q$. The switches active during $\phi 2$ can then be arranged such that the charge passed on to the opamp during $\phi 2$

$$Q_{as} = \left( Q_i \frac{C_{1i}}{C_T} - Q_q \frac{C_{2q}}{C_T} \right) + j \left( Q_q \frac{C_{1q}}{C_T} - \frac{C_{2i}}{C_t} \right)$$

Now by selecting

$$\frac{C_{1i}}{C_T} = a\cos\theta$$

$$\frac{C_{2q}}{C_T} = a\sin\theta$$

$$\frac{C_{1q}}{C_T} = a\sin\theta$$

$$\frac{C_{2i}}{C_T} = a\cos\theta$$

we have

$$Q_{as} = a\left[ (Q_i \cos\theta - Q_q \sin\theta) + j(Q_q \sin\theta - Q_i \cos\theta) \right]$$

which gives

$$\frac{C_3}{C_T} = 1 - a(\cos\theta + \sin\theta)$$

These equations can be solved for each value of $\theta$. Then the phase, $\theta$, stored in the digital accumulator can be digitally decoded to switch the appropriate set of sampling capacitors into the sampler. Thanks to symmetry in the quadrants, there will only be four sets of capacitors to switch for this 16 phase example.

Since $C_3$ contains a charge that will be thrown away, it represents a signal loss and we would like to keep it as small as possible in every case for $\theta$ The smallest value for $C_3$ occurs when $\theta$ is a multiple of n/2. When $\Theta = \pi/4$,

$$\cos\theta = \sin\theta = \frac{1}{\sqrt{2}}\ which\ in\ turn\ gives\ a = \frac{1}{\sqrt{2}}$$

Figure 22 shows a simplified version of the sampler-DDS/Mixer-Filter combination. It is simplified in several ways. As with the previous filter schematic, it is shown as a single ended circuit where it is intended to be differential. The sampler operation has been simplified to a switched current source where $\phi_{ls}$ represents the cascode switches discussed in the previous section. The digital phase accumulator of the DDS is not shown, and the decode logic to generate $\phi_{lDDS}$ or $\phi_{2DDS}$ is not shown. Further, the switches and capacitors are shown for only one of 16 possible phase shifts of the DDS/Mixer.

The operation of what is shown is as follows: The sampler is initialised by closing $\phi_{lDDS}$ and switching in a set of 6 capacitors, $C_{i1}$, $C_{i2}$, $C_{i3}$, $C_{q1}$, $C_{q2}$ and $C_{q3}$, during $\phi$. In this set, $C_{i1} + C_{i2} + C_{i3}$ is equal to $C_1$ in the previous section on the sampler. Switching this capacitor set in during $\phi$ allows any charge injected by this switching operation to be shunted to ground. Then with the particular set of capacitors switched into the sampler, $\phi$, opens and initialisation of the sampler is complete. During $\phi_{ls}$, a charge is sampled onto this set of capacitors. The set of capacitors is chosen by the two LSBs of the digital phase accumulator and perform a phase shift of some amount less than $\pi/2$. This can be seen by imagining that if $C_{i1} = C_{q1} > C_{i2} = C_{q2}$, most of the signal sampled onto $C$, passes on to the filter with a small phase shift; while if $C_{i1} = C_{q1} < C_{i2} = C_{q2}$, most of the signal gets shifted by $\pi/2$. That is, more of the signal sampled on the in-phase channel gets shifted to the real channel and more of the signal sampled on the real channel gets shifted to the quadrature channel. Four such sets of capacitors and switches could then provide four discrete phase shifts within one quadrant of the mixer. The net result is that at the end of $\phi$, the complex sample is phase-shifted by an amount determined by the two LSBs of the digital phase accumulator.

Figure 22 shows the application of this phase-shifted sample to the filter during $\phi_{2DDS}$. In the example shown, this phase-shifted charge sample is transferred onto the integrating capacitors, $C_1$ by the opamps. The one quadrant phase-shift built into the sampler can be extended to the other three quadrants by having four sets of switches for $\phi_{2DDS}$ which connect the sampled charge to the filter in different configurations. Specifically, for another n/2 phase-shift, $\phi_{2DDS}$ could swap the $C_1$ with the $C_q$, which a long with an appropriate inversion of one of the channels could be arranged to add another n/2 of phase shift to the complex sample. Alternatively, an extra phase shift of n could be arranged by inverting both in-phase and quadrature samples. The net result of the one quadrant 4 position phase-shift during $\phi_1$ and the four quadrant 4 position phase shift during $\phi_2$ is a 4 quadrant 16 position phase-shift which is under the control of the digital phase accumulator. This is the equivalent of a DDS and a complex mixer as desired.

Additional downconversion stages may be added after the DDS-Mixer. There are two major cases in this PLL analysis. In the first case, we will have a preliminary look at a "Heterodyne Loop" which has been described, for conventional PLLs, in other sources. Application of the heterodyne loop to a CV$\Delta\Sigma$PLL is also advantageous. In the second case, we will look at the "Long Loop" concept which can be applied advantageously to the CV$\Delta\Sigma$PLL.

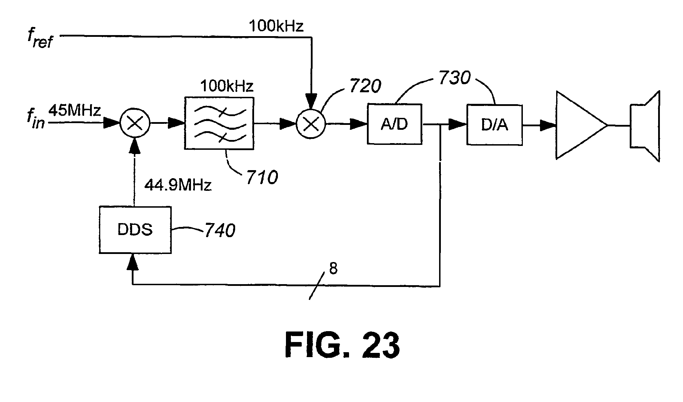

A high resolution version of a demodulator is shown in Figure 23. This PLL when used with a VCO has been called a "Heterodyne Loop" by others. Its operation is as follows: The input frequency $f_{in}$ from' the conversion stage is mixed with the output of a Direct Digital Synthesizer (DDS) to some IF frequency. For example, the 45 MHz first IF we wish to demodulate is mixed to a second IF near 100 kHz, where it is band-pass filtered (710). This 100 kHz second IF is then compared 720 to a 100kHz reference frequency and phase detected. The detected phase error is then A/D converted and used to drive the DDS, locking the loop. If the loop is to remain phase locked, the signal driving the DDS must represent the input frequency (with a 100 kHz IF offset). Thus, if we had an 8 bit A/D / D/A pair 730 and an 8 bit DDS 740 with a 44.9 MHz output frequency most of our problems would be solved, but at the expense of considerable power consumption.

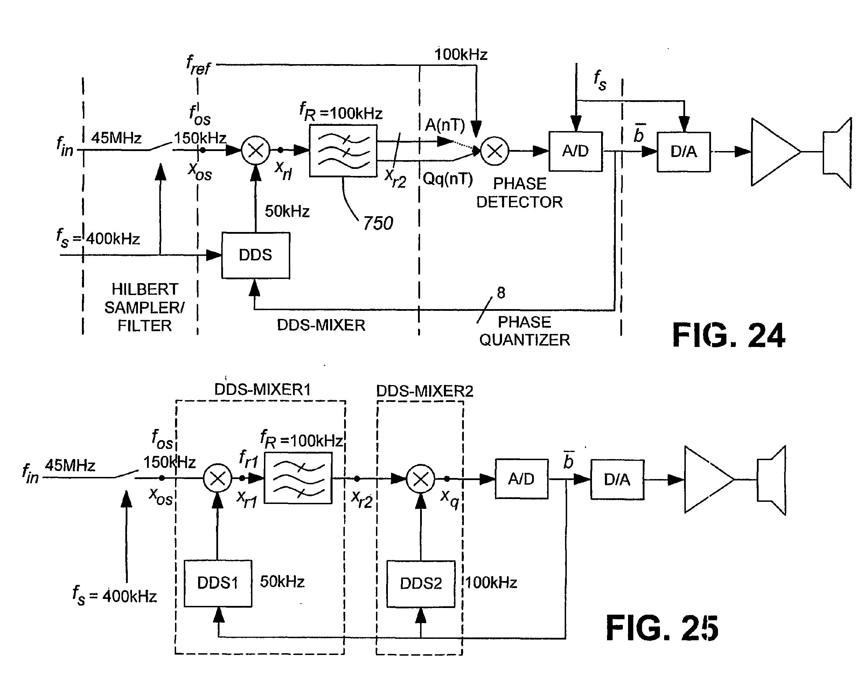

The first step towards power reduction is to sub-sample the 45 MHz first IF to produce in phase and quadrature samples at the clock frequency for the DDS and the A/D, which is $f_s$, as shown in Figure 24. The sub-sampling should not cause noise or other aliasing problems if an off-chip IF filter has sufficient selectivity and stop band attenuation to anti-alias the first IF signal. To be more specific, the IF filter must attenuate noise and interference more than ½ the sub-sampling frequency away from the IF to the point where it is insignificant. If we pick the sub-sampling frequency to be 44.85 MHz/112 which is near 400 kHz, the sub-sampling then aliases the 45 MHz first IF to a second IF at 150 kHz. Mixing this IF with the DDS 740, which is producing a 50 kHz output, then produces a third IF at 100 kHz, which is the band pass filter 750 as shown. Under these conditions, the DDS clock can be reduced from over 90 MHz in the previous example to only 400 kHz here. This results in the demodulator of Figure 24.

For now we can ignore the details of how to perform the sampling operation and consider the sequence of samples, $\chi$as, at 400 kHz to be the input to the demodulator. These samples can be thought of as complex since they contain both amplitude and phase information in their I and Q components. The demodulator of Figure 24 is also a heterodyne PLL with a reduced input frequency at 150 kHz, sampled at 400 kHz. Its method of operation requires a phase lock which can only occur under certain conditions. The conditions for this demodulator to lock are simply that the frequency output from the band-pass filter must match the reference frequency. In order for this to occur, the input frequency minus the frequency generated by the DDS must equal both the centre frequency of the band pass filter and the reference frequency. The frequency output from the DDS is,

$$\frac{\bar{b}}{R_{DDS1}} fs(A)$$

where -b is the average output of the A/S converter and $R_{DDSI}$ is the resolution of the DDD so the constraint becomes

$$f_{as} - \frac{\bar{b}}{R_{DDS1}} f_s = f_r = f_{ref}$$

where $f_{as}$ is the input offset frequency we wish to receive, $f_R$ is the centre frequency of the band pass filter, and $f_{ref}$ is the reference frequency. A numerical example of this lock condition may help to illustrate the meaning of equation A and the operation of the loop. If we consider a simple case where there is no modulation on the original 45 MHz carrier and nQ interference, then the input frequency, $f_{os}$, is a single tone at 150 kHz, and the output of the loop, should be a fixed dc value corresponding to this input frequency. With a reference frequency of 400 kHz, and a resolution of $R_{DDS1}$ = 256 that is 8 bits, the average input to the DDS which will produce a 50 kHz DDS output with a 400 kHz clock is

$$\bar{b} = \frac{50kHz}{400kHz} 2^8 = 32$$

If the output of the A/D is less than 32, then the DDS output frequency will be less than 50 kHz. This will cause a frequency error (i.e. a ramp in phase error) at the 100 kHz phase detector. This will in turn correct the A/D output until it is 32. This way the loop always corrects itself to satisfy the lock condition of equation (12). Now, if we allow the input to have some FM modulation, it is fairly easy to imagine that the PLL can track this modulation by adjusting the A/D output number. That is, the loop can be identified as a frequency-to-digital frequency discriminator.

Another approach to the above, is the "Long PLL". In this PLL we generate two phase locked loops which establish two simultaneous constraints on the frequency of the lock condition. As a result of these two simultaneous constraints there is only one offset frequency and corresponding b which can satisfy the phase-lock conditions, and then if the loop is properly designed, the PLL either locks to the assigned channel or does not lock. The result of this extra constraint is that the filtering of the band pass filter is always used to attenuate the alternate channel.

The "Long Loop" is illustrated in Figure 25. Its first mixer (DDS-Mixer) is similar in operation to the "Heterodyne Loop" previously discussed. One difference from the Heterodyne Loop is that the signal at the band pass filter output is no longer phase locked to a fixed reference. Instead it is phase locked to another DDS whose frequency also depends on the A/D output. This sets up a more complicated set of constraints for the loop to lock, which we can now analyze.

As in the "Heterodyne Loop" previously discussed, this first mixer gives a constraint on frequencies that can pass through the resonator without attenuation.

$$f_{as} - \frac{\bar{b}}{R_{DDS1}} f_s = f_{R1}$$

Similarly the second DDS/mixer combination (DDS-Mixer 2) mixes the IF frequency down to dc. Unlike the "Heterodyne Loop" previously discussed, the reference frequency which mixes the IF frequency down to dc is now dependent upon the output of the A/D converter. Now the second DDS/mixer combination gives the constraint

$$f_{R1} - \frac{b}{R_{DDS2}} f_S = 0$$

Solving these two constraints for $f_{as}$ by eliminating b gives

$$f_{as} = f_{R1} \left( \frac{R_{DDS1}}{R_{DDS2}} + 1 \right)$$

Now by picking the resolution of the two DDS accumulators, and the resonant frequency of the resonator, the demodulator can be constrained to receive only the assigned channel, even if it is weaker than the alternate channel.

After the last (or only) DDS/mixer combination, the signal is finally downconverted to dc and held in phase lock to 0 Hz. This is accomplished by quantising the complex phase angle of $x_q(nT) = A(nT) + j\ Qq(nT)$. Since the signal is complex, the quantiser can determine the phase of the complex voltage, $x_q(nT)$. In general, this would require a transcendental function to perform $\tan^{-1}(\mathrm{Im}(x_q)/\mathrm{Re}(x_q))$. One approach along these lines is to perform an A/D conversion of both A$(nT)$ and $Qq(nT)$. Then a lookup table could table could perform a inverse tangent to obtain a quantised phase angle.

However, in the case of a single bit phase quantiser, we only want to know if $x_q(t)$ is leading or lagging. The situation is simplified by the fact that $\mathrm{sign}(\tan^{-1}(\mathrm{Im}(x_q)/Re(x_q))) = \mathrm{sign}(\mathrm{Im}(x_q))$ and as a result simply quantising the imaginary part of $x_q$ tells if the phase is leading or lagging, assuming that interference have not corrupted the decision. If the phase of the signal being quantised is leading, a one is produced by the quantiser; if it is lagging, a zero is produced. Only this bit stream from the quantised phase information is used for feedback in the phase locked loop. Negative feedback in the PLL then holds this imaginary component close to 0. Since we have quantised this error signal to a single bit, the PLL is also a $\Delta\Sigma$ loop and same residual quantisation noise is present throughout the PLL.

Since the phase locking $x_q$ holds the imaginary component close to 0, the magnitude of $x_q$ is in the real component, A(nT). This component is ignored for the PLL but can be conveniently used in an AGC loop or as received signal strength indicator (RSSI).

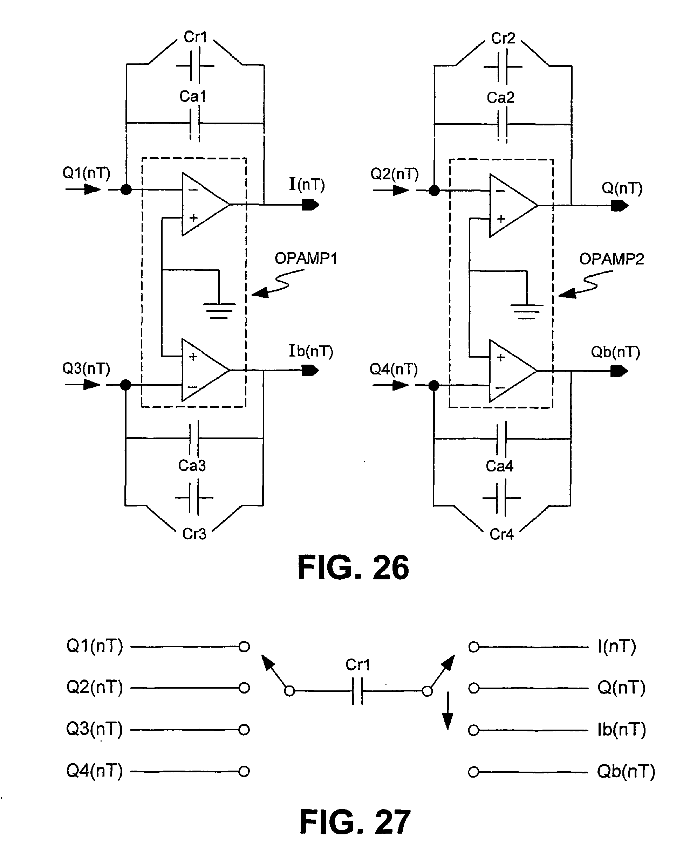

Another possible configuration for a complex filter is that illustrated in Fig 26.

Figure 26 shows a simplified schematic of a one pole complex filter. The charge sampled on each of the four phases of the sampling filter is passed to the virtual ground of the operational amplifiers (opamp 1 and opamp 2) which in turn transfer it to the Ca and Cr capacitors on each of the four phases of the one pole filter.

The unique feature of this complex filter is that cross-coupling between the I and Q channels (to frequency shift the location of the pole) is achieved by rotating the Cr capacitors in the complex plane. This rotation is arranged so that Cr1 on one phase of the switch closing performs a charge sharing operation with Ca1. The next time the switches close, Cr1 performs a charge sharing operation with Ca2, then Ca3, then Ca4 and finally back to Ca1. Similarly, each one of the other Cr capacitors performs charge sharing operations with each one of the Ca capacitors in sequence.

This method of rotating the capacitors requires a more complicated switch matrix than is shown in Figure 26. For example, the switch illustrating a connection from the I(nT) output to the bottom plate of Cr1 actually represents four switches which close in sequence connecting, in turn, Cr1, Cr4, Cr3 and then Cr2 to Ca1.

The four charges $Q_1(nT)$ to $Q_4(nT)$ are integrated to feedback capacitors $C_r$ and $C_a$ during the sampling interval T by the subscampler stage presented above. The capacitors $C_a$ have their fixed positions in feedback, whereas capacitors $C_r$ are connected to switch matrices to a feedback loop. The function of the switch matrices is to rotate the capacitors $C_r$ from one feedback loop to another at the sampling times t = nT. Rotation direction is as shown in Figure 27. For example, the capacitor $C_{r1}$ connected to I at the previous sampling period is connected to Q at the next period.

To understand the operation of the above circuit as a complex filter, it is convenient to imagine that I, Ib, Q and Qb collectively represent a single complex value, V = I - Ib+j(Q - Qb). Then, on each rotation of the rotating capacitors Cr, the charge on the Cr capacitors is rotated 90 degrees in the complex plane and

$$V(z) = \frac{Ca}{Ca + Cr} V(z)z^{-1} + j\frac{Cr}{Ca + Cr} V(z)z^{-1} + Q(z)\frac{1}{Ca + C}$$

or

$$\frac{V(z)}{Q(z)} = \frac{\delta}{1 - \gamma z^{-1}}$$

wh ere

$$\gamma = \alpha + j\beta = \frac{Ca + jCr}{Ca + Cr} \qquad \delta = \frac{1}{Ca + Cr}$$

The above method of switching capacitors has at least one specific use. In traditional switched capacitor single pole filters, mismatch of the capacitors would cause inaccuracy of the filter function, thereby producing an image of both desired and undesired signals with opposite frequency. This interference can be difficult to remove. With the method above, capacitor mismatches result in tones at predetermined frequencies (modulated by the filtered data). This interference can be removed by further filtering.

A person understanding the above-described invention may now conceive of alternative designs, using the principles described herein. All designs which fall within the scope of the claims appended hereto are considered to be part of the present invention.

## Claims

1. A Hilbert sampler/filter circuit comprising:

    a grounding switch (560);
    a circuit element (540) having a transconductance and receiving an input signal;
    a plurality of primary and secondary sampler cells, each sampler cell being coupled to both the output of the circuit element and the grounding switch at a common node (ca1, ca2, ca3, ca4);
    an array of coupling switches for coupling any one of said primary sampler cells with any one of said secondary sampler cells,
    wherein the grounding switch, when closed, couples said circuit element and each sampler cell to ground each primary sampler cell producing an output of said circuit.

2. A sampler/filter circuit as in claim 1 wherein each primary sampler cell comprises:

    a buffer (590) coupled between a primary sampler cell output ($V_1$) and a first connection node (580):
    a first capacitor coupled (570) between ground and the first connection node;
    a sampling switch (620) coupled between the circuit element and a second connection node (600);
    an activation switch (610) coupled between the second connection node and the first connection node; wherein
    said array of coupling switches is coupled to each primary sampler cell at the second connection node;
    the state of the grounding switch is always opposite to the state of the sampling switch.

3. A sampler/filter circuit as in claim 2 wherein each secondary sampler cell comprises a second capacitor (550) coupled between ground and at least one of the array of coupling switches, each one of said array of coupling switches comprising at least one coupling switch coupled between the second capacitor of a secondary sampler cell and a second connection node of a primary sampler cell.

## Patentansprüche

1. Hilbert-Abtaster-/Filterschaltung, enthaltend
    einen Erdungsschalter (560);
    ein Schaltungselement (540), das einen Gegenwirkleitwert aufweist und ein Eingangssignal empfängt;
    eine Vielzahl von primären und sekundären Abtaster-Zellen, wobei jede Abtaster-Zelle sowohl mit dem Ausgang des Schaltungselements als auch dem Erdungsschalter an einem gemeinsamen Knoten (550) gekoppelt ist;
eine Anordnung von Kopplungsschaltern zum Koppeln jeder beliebigen der primären Abtaster-Zellen mit jeder beliebigen der sekundären Abtaster-Zellen,
wobei der Erdungsschalter im geschlossenen Zustand das Schaltungselement und jede Abtaster-Zelle mit der Erde koppelt, wobei jede primäre Abtaster-Zelle ein Ausgangssignal der Schaltung erzeugt.

2. Abtaster-/Filterschaltung nach Anspruch 1, bei welcher jede primäre Abtaster-Zelle enthält:

einen Puffer (590), der zwischen einen Ausgang ($V_1$) einer primären Abtaster-Zelle und einen ersten Verbindungsknoten (580) geschaltet ist;
einen ersten Kondensator (570), der zwischen Erde und den ersten Verbindungsknoten geschaltet ist;
einen Sampling-Schalter (620), der zwischen das Schaltungselement und einen zweiten Verbindungsknoten (600) geschaltet ist;
einen Aktivierungsschalter (610), der zwischen den zweiten Verbindungsknoten und den ersten Verbindungsknoten geschaltet ist;
wobei
die Anordnung von Kopplungsschaltern an dem zweiten Verbindungsknoten mit jeder primären Abtaster-Zelle gekoppelt ist;
der Zustand des Erdungsschalters stets dem Zustand des Sampling-Schalters entgegengesetzt ist.

3. Abtaster-/Filterschaltung nach Anspruch 2, bei welcher jede sekundäre Abtaster-Zelle einen zweiten Kondensator (Ca1, Ca2, Ca3, Ca4) enthält, der zwischen Erde und mindestens einen der Anordnung von Kopplungsschaltern geschaltet ist, wobei jeder der Anordnung von Kopplungsschaltern mindestens einen Kopplungsschalter enthält, der zwischen den zweiten Kondensator einer sekundären Abtaster-Zelle und einen zweiten Verbindungsknoten einer primären Abtaster-Zelle geschaltet ist.

## Revendications

1. Un échantillonneur de Hilbert / circuit de filtrage comprenant:

- un commutateur de mise à la masse (560);
- un élément de circuit (540) ayant une transconductance et recevant un signal d'entrée;
- une pluralité de cellules échantillonneuses primaires et secondaires, chaque cellule échantillonneuse étant couplée à la fois à la sortie de l'élément de circuit et au commutateur de mise à la masse à un noeud commun (550);
- un réseau de commutateurs de couplage pour coupler l'une quelconque desdites cellules échantillonneuses primaires avec l'une quelconque desdites cellules échantillonneuses secondaires,
dans lequel le commutateur de mise à la masse, lorsqu'il est fermé, couple ledit élément de circuit et chaque cellule échantillonneuse à la masse, chaque cellule échantillonneuse primaire produisant un signal de sortie dudit circuit.

2. Un échantillonneur / Circuit de filtrage selon la revendication 1, dans lequel chaque cellule échantillonneur primaire comprend:

- une mémoire tampon (590) couplée entre une sortie (V1) de la cellule échantillonneuse primaire et un premier noeud de connexion (580);
- un premier condensateur (570) couplé entre la masse et le premier noeud de connexion;
- un commutateur d'échantillonnage (620) couplé entre l'élément de circuit et un second noeud de connexion (600);
- un commutateur d'activation (610) couplé entre le deuxième noeud de connexion et le premier noeud de connexion;
dans lequel
ledit réseau de commutateurs de couplage est couplé à chaque cellule échantillonneuse primaire au second noeud de connexion;
l'état de l'interrupteur de mise à la masse est toujours opposé à l'état du commutateur d'échantillonnage.

3. Un échantillonneur / Circuit de filtrage selon la revendication 2, dans lequel chaque cellule échantillonneuse secondaire comprend un second condensateur (Ca1, Ca2, Ca3, Ca4) couplé entre la masse et au moins un commutateur du réseau de commutateurs de couplage, chaque commutateur dudit réseau de commutateurs de couplage comprenant au moins un commutateur de couplage couplé entre le second condensateur d'une cellule échantillonneuse secondaire et un second noeud de connexion d'une cellule échantillonneuse primaire.

(PRIOR ART)

# FIG. 1

(PRIOR ART)

# FIG. 2A

(PRIOR ART)

# FIG. 2B

(PRIOR ART)

# FIG. 2C

(PRIOR ART)

# FIG. 3A

# FIG. 3B

(PRIOR ART)

# FIG. 4

$A(t)e^{j\omega_c t}$

$A(t)\cos(\omega_c t)$ → **HILBERT TRANSFORMER** → ⊗ → $\widehat{A}(t)$, $\widehat{\varphi}(t)$

VCO

(PRIOR ART)

# FIG. 5

**FIG. 6**

**FIG. 7**

**FIG. 8**

**FIG. 9**

**FIG. 10**

**FIG. 11A**

FIG. 11B

FIG. 12

FIG. 13A

**FIG. 13B**

**FIG. 15**

**FIG. 14**

FIG. 16

FIG. 17

FIG. 18

FIG. 19

**FIG. 20**

**FIG. 21**

**FIG. 22**

**FIG. 23**

FIG. 24

FIG. 25

**FIG. 26**

**FIG. 27**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5533071 A